# FASCICULE DE BREVET EUROPEEN

(11) **EP 3 034 460 B1**
(45) Date de publication et mention de la délivrance du brevet: **09.09.2020**
(21) Numéro de dépôt: 15200572.4
(22) Date de dépôt: 16.12.2015
(51) Int. Cl.: B81C 1/00

(54) **STRUCTURE GETTER MULTI-NIVEAUX ET STRUCTURE D'ENCAPSULATION COMPORTANT UNE TELLE STRUCTURE GETTER MULTI-NIVEAUX**
MEHRSTUFIGE GETTER-STRUKTUR UND EINKAPSELUNGSSTRUKTUR, DIE EINE SOLCHE MEHRSTUFIGE GETTER-STRUKTUR UMFASST
MULTI-LEVEL GETTER STRUCTURE AND ENCAPSULATION STRUCTURE COMPRISING SUCH A MULTI-LEVEL GETTER STRUCTURE

(30) Priorité: 17.12.2014 FR 1462587
(43) Date de publication de la demande: 22.06.2016
(73) Titulaire: Commissariat à l'Énergie Atomique et aux Énergies Alternatives, 75015 Paris (FR)
(72) Inventeur: BAILLIN, Xavier, 38920 CROLLES (FR)
(74) Mandataire: Brevalex

(56) Documents cités:
- US-A- 5 864 205
- US-A1- 2010 314 544
- US-A1- 2011 079 889

## Description

### DOMAINE TECHNIQUE ET ART ANTÉRIEUR

L'invention concerne une structure getter multi-niveaux, ainsi qu'une structure d'encapsulation comprenant une cavité hermétique dans laquelle sont encapsulés un ou plusieurs micro-dispositifs, également appelés microsystèmes ou microcomposants, par exemple de type MEMS (microsystème électromécanique), NEMS (nano-système électromécanique), MOEMS (microsystème opto-électro-mécanique), NOEMS (nanosystème opto-électro-mécanique), ou de type micro-détecteur infrarouge, et une ou plusieurs structures getter multi-niveaux. L'invention concerne également un procédé de réalisation d'une telle structure getter multi-niveaux, ainsi que des procédés d'encapsulation d'au moins un micro-dispositif permettant de réaliser une structure d'encapsulation du micro-dispositif comportant une ou plusieurs structures getter multi-niveaux.

Certains micro-dispositifs, tels que ceux de type MEMS, NEMS, MOEMS, NOEMS ou des micro-détecteurs infrarouges, nécessitent pour leur bon fonctionnement d'être enfermés, ou encapsulés, de manière hermétique dans une cavité dont l'atmosphère est contrôlée (contrôle de la nature du ou des gaz présents dans la cavité et/ou de la pression dans la cavité).

Une telle encapsulation peut être réalisée de manière collective pour plusieurs micro-dispositifs réalisés sur un même substrat (ou wafer), appelé premier substrat. Chacun des micro-dispositifs est alors encapsulé dans une cavité formée par le report et le scellement hermétique d'un capot, par exemple formé par un deuxième substrat de silicium ou de verre, sur le premier substrat. Cet assemblage hermétique entre le premier et le deuxième substrats, appelé « wafer-to-wafer », ou W2W, et formant de manière collective les cavités d'encapsulation des micro-dispositifs, permet de protéger l'atmosphère régnant dans les cavités en empêchant les fuites de gaz entre l'intérieur des cavités et l'environnement extérieur à la structure d'encapsulation. En variante, les cavités peuvent être formées par une encapsulation de type TFP (« Thin Film Packaging »), ou PCM (« Packaging Couche Mince »), les capots étant dans ce cas formés d'une ou plusieurs couches minces superposées.

L'ajout de getters non évaporables (NEG) dans les cavités, par exemple sous la forme de portions de matériau getter disposées dans ces cavités, permet de contrôler les caractéristiques de l'atmosphère au sein des cavités. Les portions de matériau getter peuvent être réalisées à partir d'un dépôt en couche mince du matériau getter sur le premier substrat et/ou, dans le cas d'une encapsulation W2W, sur le deuxième substrat, préalablement à l'opération d'assemblage entre les deux substrats. Une mise en forme des portions de matériau getter dans le plan de la surface du substrat sur laquelle le matériau getter est déposé est ensuite réalisée en mettant en œuvre des opérations technologiques de photolithographie et de gravure de la couche mince de matériau getter.

Dans le cas d'une encapsulation PCM, le matériau getter peut être réalisé sous la forme d'une couche mince correspondant à la première couche d'un empilement de couches destiné à former le capot et formant ainsi la paroi intérieure du capot qui est exposée à l'intérieur de la cavité.

En variante, il est possible de déposer le matériau getter de manière discrète, directement sous la forme souhaitée. Pour cela, le matériau getter peut être déposé directement sur l'un et/ou l'autre des deux substrats soit à travers d'un pochoir, soit par lift-off, à travers un film de résine photosensible préalablement mis en forme par photolithographie, ce film étant retiré après le dépôt du matériau getter à travers celui-ci.

En général, lors d'un assemblage W2W, le dépôt du getter est monolithique et de forme carrée ou rectangulaire, et seule la face opposée à la face en contact avec le substrat d'accueil est au contact de l'atmosphère de la cavité. Le getter peut être déposé sur le substrat qui accueille le dispositif, ou sur le substrat formant le capot. Dans le cas d'une encapsulation PCM, le getter peut être déposé de la façon identique au cas précèdent sur le substrat, ou sur la couche sacrificielle avec la couche capot qui est ensuite formée en recouvrant le getter et la couche sacrificielle.

Pour certaines applications, notamment le packaging individuel de micro-bolomètres formant chacun un pixel d'une matrice de détection (chaque pixel est packagé indépendamment des autres), l'intégration d'un matériau getter dans les structures d'encapsulation pose des problèmes en raison du peu de place disponible, ou encore en raison des procédés agressifs mis en œuvre lors de l'intégration du matériau getter qui conduisent à réduire sa capacité de pompage gazeux, ou capacité d'absorption/d'adsorption des gaz.

Il convient donc de trouver une solution pour augmenter la capacité de pompage du matériau getter sans pour autant augmenter son encombrement.

Afin d'accroître la surface de matériau getter exposée, le document FR 2 976 933 A1 décrit une structure getter formée par un matériau getter déposé sur un matériau perméable aux gaz et telle que la face du matériau getter en contact avec le matériau perméable aux gaz soit apte à réaliser une adsorption/absorption gazeuse via ce matériau perméable. La structure getter peut également comporter plusieurs portions de matériau getter superposées les unes aux autres et espacées les unes des autres par des portions de matériau perméable aux gaz. Cette structure getter permet de multiplier par deux la capacité de pompage de chacune des portions de matériau getter de la structure getter.

Cependant, cette structure getter repose sur l'emploi d'une couche poreuse (par exemples un composé de type SiOxCy déposé par CVD, ou dépôt chimique en phase vapeur, ou un métal déposé par PVD, ou dépôt physique en phase vapeur) dont il convient de savoir gérer la structure de façon à assurer une bonne porosité au matériau (il faut trouver le compromis entre structure poreuse et structure dense, sachant que les mécanismes de croissance des dépôts métalliques autorisant une telle structure se situent vers les basses températures, proches de la température ambiante, selon les métaux). Il est également nécessaire de s'assurer de la stabilité chimique de la couche poreuse lorsqu'elle comporte du SiO_{X}C_{Y} puisqu'elle contient de l'oxygène et du carbone et risque donc d'être réactive vis-à-vis de l'atmosphère ambiante, ce qui nécessite de la protéger rapidement après dépôt. Enfin, la réalisation d'une telle structure getter implique de réaliser les portions de matériau getter et les portions de matériau perméable selon différents motifs, ainsi que de recouvrir d'une couche de protection l'ensemble de l'empilement.

De plus, lorsque le matériau perméable aux gaz est formé par une structure gravée comportant des canaux, ces canaux doivent être recouverts par le dépôt de matériau getter sans toutefois être bouchés par celui-ci. La largeur des canaux est donc limitée à quelques microns. La surface de matériau getter, au niveau de sa face qui est en contact avec les canaux, est donc également limitée.

Le document FR 2 933 389 A1 décrit une structure getter suspendue pour laquelle la face supérieure et une partie de la face inférieure du matériau getter sont aptes à piéger les gaz qui l'entourent. Dans cette structure, la portion de matériau getter est déposée sur un support lui-même disposé sur un substrat. Grâce au support, cette structure permet d'augmenter la surface d'absorption/d'adsorption des gaz par rapport à une même portion de matériau getter déposée directement sur le substrat. Toutefois, l'augmentation de la capacité de pompage obtenue reste limitée.

Le document FR 2 933 390 A1 décrit la réalisation d'une structure d'encapsulation de type PCM dans laquelle la couche de matériau getter est utilisée pour former le capot de la structure d'encapsulation ou pour former une couche de séparation entre deux cavités superposées l'une sur l'autre. Dans ce deuxième cas, la portion de matériau getter est exposée par ces deux faces, ce qui double environ sa capacité de pompage pour une surface équivalente déposée sur un support.

Cependant, une telle structure d'encapsulation comportant la couche de matériau getter formant une couche de séparation entre deux cavités superposées l'une sur l'autre est limitée à des surfaces de matériau getter relativement faibles afin de ne pas affecter la stabilité mécanique du matériau getter, cette couche de matériau getter étant uniquement ancrée au niveau des bords de la structure d'encapsulation.

Pour augmenter la surface d'absorption d'un matériau getter, il est également connu de le déposer sur une surface présentant des reliefs. Cependant, la création de tels reliefs ajoute un certain nombre d'opérations technologiques complexifiant le procédé d'encapsulation.

Les documents US 2011/0079889, US 5 864 205 et US 2010/0314554 décrivent des structures getter comprenant plusieurs couches de matériau getter. Les structures des documents US 5 864 205 et US 2010/0314554 contient une ouverture débouchant un espace entre les couches de getter permettant la circulation de gaz dans l'espace entre les deux couches de getter. Le document US 2010/0314554 décrit une structure getter dans le domaine de micro-structures comme le préambule de la revendication 1.

### EXPOSÉ DE L'INVENTION

Un but de la présente invention est de proposer une nouvelle structure getter présentant un encombrement réduit, dont la surface ne soit pas limitée notamment pour des raisons de stabilité mécanique et, pour une surface d'occupation donnée, une capacité de pompage accrue par rapport aux structures getter de l'art antérieur, et cela sans avoir recours à des matériaux poreux ou perméables aux gaz ni à des reliefs sur le support sur lequel le matériau getter est disposé.

Pour cela, la présente invention propose une structure getter comportant au moins :
- un support ;
- une première couche de matériau getter disposée sur le support ;
- une deuxième couche de matériau getter telle que la première couche de matériau getter soit disposée entre le support et la deuxième couche de matériau getter;
- une première portion de matériau reliant mécaniquement une première face de la deuxième couche de matériau getter à une première face de la première couche de matériau getter et formant au moins un premier espace entre les premières faces des première et deuxième couches de matériau getter permettant une circulation de gaz entre les premières faces des première et deuxième couches de matériau getter;
- une première ouverture traversant au moins la deuxième couche de matériau getter et débouchant dans le premier espace.

Dans une telle structure getter, les couches de matériau getter sont disposées les unes au-dessus des autres, ce qui permet à cette structure de présenter un encombrement réduit.

Une telle structure getter peut donc réaliser une absorption et/ou une adsorption de gaz depuis la face de la deuxième couche de matériau getter qui est opposée à celle en contact avec la première portion de matériau (cette face pouvant former la surface supérieure de la structure getter), mais également depuis les premières faces des première et deuxième couches de matériau getter grâce au premier espace formé entre ces premières faces et grâce à la première ouverture (ou aux premières ouvertures) qui met en communication le premier espace avec l'environnement extérieur à la structure getter. Ainsi, pour une même surface d'occupation sur le support, cette structure getter permet par exemple de multiplier par environ trois (voire plus si la structure getter comporte un nombre plus important de couches de matériau getter) la capacité d'absorption et/ou d'adsorption des gaz obtenue comparé à une simple couche de matériau getter disposée sur le support. De façon plus générale, la structure getter permet, avec n couches de matériau getter (n étant un nombre entier strictement supérieur à 1), de disposer de 2n-1 faces actives de matériau getter, une face active correspondant à une face d'une couche de matériau getter susceptible d'être en contact avec un ou plusieurs gaz à absorber et/ou à adsorber. Il est ainsi possible, lorsque la structure getter fait partie d'une structure d'encapsulation d'un micro-dispositif, de localiser judicieusement la structure getter dans des zones de la structure d'encapsulation qui peuvent être étroites et de façon à ne pas perturber le fonctionnement du micro-dispositif.

Une telle structure getter a également pour avantage de pouvoir être réalisée avec n'importe quelle géométrie, selon la place disponible, et sans être limitée nécessairement à des petites surfaces.

Cette structure getter est également compatible avec toutes les structures d'encapsulation, qu'elles soient du type W2W ou PCM, et est également compatible avec une encapsulation collective de plusieurs micro-dispositifs sous atmosphère contrôlée.

La structure getter peut comporter en outre au moins :
- une troisième couche de matériau getter telle que la deuxième couche de matériau getter soit disposée entre la première couche de matériau getter et la troisième couche de matériau getter ;
- une deuxième portion de matériau reliant mécaniquement une première face de la troisième couche de matériau getter à une deuxième face de la deuxième couche de matériau getter et formant au moins un deuxième espace entre lesdites faces des deuxième et troisième couches de matériau getter permettant une circulation de gaz entre lesdites faces des deuxième et troisième couches de matériau getter ;
- une deuxième ouverture traversant au moins la troisième couche de matériau getter et débouchant dans le deuxième espace.

Dans cette configuration, pour une même surface d'occupation sur le support, cette structure getter permet par exemple de multiplier par environ cinq la capacité d'absorption et/ou d'adsorption des gaz obtenue comparé à une simple couche de matériau getter disposée sur le support. La mise en communication des premier et deuxième espaces avec l'environnement extérieur est réalisée grâce aux première et deuxième ouvertures.

La structure getter peut comporter n couches de matériau getter superposées, espacées les unes des autres et structurées telles que 2n-1 faces actives de matériau getter soient susceptibles d'être en contact avec un ou plusieurs gaz à absorber et/ou à adsorber, avec n nombre entier tel que n > 1. Les 2n-1 faces actives peuvent être destinées à être exposées à la circulation de gaz.

Chaque couche de matériau getter de la structure getter peut être ou non formée de plusieurs sous-couches de matériau getter, c'est-à-dire formée d'un empilement de plusieurs couches de matériau getter disposées les unes contre les autres.

Suivant les applications visées pour la structure getter, la dernière couche de matériau getter de la structure getter (c'est-à-dire celle la plus éloignée du support) peut être recouverte d'une couche spécifique à l'application visée. Par exemple, pour une application du domaine de l'infrarouge, la dernière couche de matériau getter, formant une face avant de la structure getter, peut être recouverte d'une couche réflectrice comportant par exemple de l'aluminium.

Le matériau de la première portion peut être apte à être gravé sélectivement par rapport aux matériaux getter des première et deuxième couches et/ou, lorsque la structure getter comporte la troisième couche de matériau getter, le matériau de la deuxième portion peut être apte à être gravé sélectivement au moins par rapport aux matériaux getter des deuxième et troisième couches (et éventuellement être également apte à être gravé sélectivement par rapport au matériau getter de la première couche). Ainsi, les première et deuxième portions de matériau disposées entre les différentes couches de matériau getter peuvent être aisément réalisées à partir de couches de matériau sacrificiel initialement disposées entre les couches de matériau getter.

Lorsque le matériau de la première portion est similaire, ou de même nature, à celui de la deuxième portion, ce matériau peut avantageusement être apte à être gravé sélectivement par rapport aux matériaux getter des première, deuxième et troisième couches de matériau getter.

Les matériaux getter des première et deuxième couches peuvent comporter au moins du Ti et/ou du Zr et/ou du V, et le matériau de la première portion peut comporter au moins du Ru et/ou du Cr et/ou du Cu et/ou du Ni et/ou de l'Al et/ou de l'Au, et/ou, lorsque la structure getter comporte la troisième couche de matériau getter, les matériaux getter des deuxième et troisième couches peuvent comporter au moins du Ti et/ou du Zr et/ou du V, et le matériau de la deuxième portion peut comporter au moins du Ru et/ou du Cr et/ou du Cu et/ou du Ni et/ou de l'Al et/ou de l'Au. Plus généralement, les matériaux de la première et/ou de la deuxième portions peuvent comporter un métal ou un alliage dont la gravure peut être réalisée sans réduire la surface, ou altérer la capacité de pompage, des couches de matériau getter de façons significatives.

La structure getter peut comporter :
- plusieurs premières portions de matériau reliant mécaniquement la première face de la deuxième couche de matériau getter à la première face de la première couche de matériau getter, et/ou
- plusieurs premières ouvertures régulièrement réparties dans la deuxième couche de matériau getter, et/ou
- lorsque la structure getter comporte la troisième couche de matériau getter, plusieurs deuxièmes portions de matériau reliant mécaniquement la première face de la troisième couche de matériau getter à la deuxième face de la deuxième couche de matériau getter, et/ou
- lorsque la structure getter comporte la troisième couche de matériau getter, plusieurs deuxièmes ouvertures régulièrement réparties dans la troisième couche de matériau getter.

La structure getter peut être telle que :
- la ou les premières ouvertures comportent une surface totale, dans un plan parallèle à la deuxième face de la deuxième couche de matériau getter, inférieure ou égale à environ 20 % de la surface totale de la deuxième face de la deuxième couche de matériau getter, et/ou
- lorsque la structure getter comporte la troisième couche de matériau getter, la ou les deuxièmes ouvertures comportent une surface totale, dans un plan parallèle à une deuxième face de la troisième couche de matériau getter opposée à la première face de la troisième couche de matériau getter, inférieure ou égale à environ 20 % de la surface totale de la deuxième face de la troisième couche de matériau getter, et/ou
- une partie de la surface de la première face de la deuxième couche de matériau getter qui est en contact avec la ou les premières portions de matériau est inférieure ou égale à environ 20 % de la surface totale de la deuxième face de la deuxième couche de matériau getter, et/ou
- lorsque la structure getter comporte la troisième couche de matériau getter, une partie de la surface de la première face de la troisième couche de matériau getter qui est en contact avec la ou les deuxièmes portions de matériau est inférieure ou égale à environ 20 % de la surface totale de la deuxième face de la troisième couche de matériau getter.

La deuxième couche de matériau getter peut comporter une section, dans un plan parallèle à la deuxième face de la deuxième couche de matériau getter, en forme de cadre rectangulaire ou en forme de grille, et/ou, lorsque la structure getter comporte la troisième couche de matériau getter, la troisième couche de matériau getter peut comporter une section, dans un plan parallèle à la deuxième face de la troisième couche de matériau getter, en forme de cadre rectangulaire ou en forme de grille.

La structure getter peut comporter en outre au moins une sous-couche d'ajustement de la température d'activation thermique du matériau getter de la première couche, disposée entre le support et la première couche de matériau getter et comprenant au l'un des matériaux suivants : Ru, Pt, Cr, Cu, Ci, Al, Au.

La structure getter peut comporter en outre au moins une couche de protection recouvrant au moins une des faces d'une des couches de matériau getter.

Le matériau de la couche de protection peut comporter de l'Au et/ou du Cr et/ou un oxyde d'un l'alliage ou d'un métal formant le matériau getter contre lequel la couche de protection est disposée et/ou un nitrure de l'alliage ou du métal formant le matériau getter contre lequel la couche de protection est disposée.

La structure getter peut comporter en outre au moins une couche apte à réfléchir un rayonnement infrarouge, disposée sur une face d'une des couches de matériau getter et formant une face avant de la structure getter.

L'invention concerne également une structure d'encapsulation comportant au moins une cavité fermée hermétiquement, délimitée par des premier et deuxième substrats et dans laquelle au moins un micro-dispositif est disposé sur et/ou dans le premier substrat, et comportant en outre au moins une première structure getter telle que définie précédemment, dans laquelle le support de la première structure getter est formé par le premier substrat et/ou au moins une deuxième structure getter telle que définie précédemment et dans laquelle le support de la deuxième structure getter est formé par le deuxième substrat.

L'invention concerne également une structure d'encapsulation comportant au moins une cavité fermée hermétiquement, délimitée par un substrat et un capot et dans laquelle au moins un micro-dispositif est disposé sur et/ou dans le substrat, et comportant en outre au moins une première structure getter telle que définie précédemment, formant au moins une paroi intérieure de la cavité et/ou au moins une deuxième structure getter telle que définie précédemment et dans laquelle le support de la deuxième structure getter est formé par le substrat.

L'invention concerne en outre un procédé de réalisation d'une structure getter, comportant au moins la mise en œuvre des étapes de :
- réalisation d'au moins une première couche de matériau getter sur un support ;
- réalisation d'au moins une première couche de matériau sacrificiel sur une première face de la première couche de matériau getter ;
- réalisation d'au moins une deuxième couche de matériau getter sur la première couche de matériau sacrificiel ;
- gravure d'au moins la deuxième couche de matériau getter, formant au moins une première ouverture traversant au moins la deuxième couche de matériau getter;
- gravure d'une partie de la première couche de matériau sacrificiel à travers la première ouverture, telle que le matériau sacrificiel restant de la première couche de matériau sacrificiel forme au moins une première portion de matériau reliant mécaniquement une première face de la deuxième couche de matériau getter à la première face de la première couche de matériau getter, et formant au moins un premier espace entre les premières faces des première et deuxième couches de matériau getter permettant une circulation de gaz entre les premières faces des première et deuxième couches de matériau getter et dans lequel débouche la première ouverture.

L'étape de gravure d'au moins la deuxième couche de matériau getter peut graver également la première couche de matériau sacrificiel et la première couche de matériau getter selon un motif similaire à celui de ladite au moins une première ouverture.

Pour effectuer simultanément la gravure de la première ouverture dans les première et deuxième couches de matériau getter ainsi que dans la première couche de matériau sacrificiel, une gravure RIE (gravure ionique réactive) peut être avantageusement mise en œuvre. Ce mode de réalisation peut être mis en œuvre notamment lorsque les couches de matériau getter ne peuvent pas être gravées sélectivement l'une par rapport à l'autre. Ce mode de réalisation peut être généralisé pour n couches de matériau getter (n > 1) dans lesquelles les ouvertures permettant la circulation du gaz peuvent être réalisées individuellement ou toutes simultanément dans chaque couche de matériau getter, en traversant l'ensemble des couches de matériau getter (notamment lorsque le même matériau getter est utilisé pour l'ensemble des couches de matériau getter) et des couches de matériau sacrificiel intercalées entre les couches de matériau getter, à l'exception éventuellement de la première couche de matériau getter qui peut ou non être gravée.

Le procédé peut comporter en outre, entre l'étape de réalisation de la deuxième couche de matériau getter et l'étape de réalisation de la première ouverture, la mise en œuvre des étapes de :
- réalisation d'au moins une deuxième couche de matériau sacrificiel sur une deuxième face de la deuxième couche de matériau getter ;
- réalisation d'au moins une troisième couche de matériau getter sur la deuxième couche de matériau sacrificiel ;
- gravure d'au moins la troisième couche de matériau getter, formant au moins une deuxième ouverture traversant au moins la troisième couche de matériau getter;
- gravure d'une partie de la deuxième couche de matériau sacrificiel à travers la deuxième ouverture, telle que le matériau sacrificiel restant de la deuxième couche de matériau sacrificiel forme au moins une deuxième portion de matériau reliant mécaniquement une première face de la troisième couche de matériau getter à la deuxième face de la deuxième couche de matériau getter, et formant au moins un deuxième espace entre lesdites faces des deuxième et troisième couches de matériau getter permettant une circulation de gaz entre lesdites faces des deuxième et troisième couches de matériau getter et dans lequel débouche la deuxième ouverture,
et dans lequel la gravure de la deuxième couche de matériau getter est réalisée après la gravure de la partie de la deuxième couche de matériau sacrificiel et à travers la deuxième ouverture. La gravure de la première couche de matériau sacrificiel peut être réalisée après la réalisation de la première ouverture.

L'invention concerne également un procédé d'encapsulation d'au moins un micro-dispositif disposé sur et/ou dans un premier substrat, comportant au moins les étapes suivantes :
- mise en œuvre d'un procédé de réalisation d'une première structure getter tel que défini précédemment et tel que le support de la première structure getter soit formé par le premier substrat et/ou d'un procédé de réalisation d'une deuxième structure getter tel que défini précédemment et tel que le support de la deuxième structure getter soit formé par un deuxième substrat ;
- solidarisation des premier et deuxième substrats l'un à l'autre, formant au moins une cavité fermée hermétiquement, délimitée au moins par les premier et deuxième substrats et dans laquelle le micro-dispositif est disposé.

L'invention concerne également un procédé d'encapsulation d'au moins un micro-dispositif disposé sur et/ou dans un substrat, comportant au moins les étapes suivantes :
- réalisation d'une portion de matériau organique sur le substrat et recouvrant au moins le micro-dispositif;
- mise en œuvre d'un procédé de réalisation d'une première structure getter tel que défini précédemment, la première couche de matériau getter étant réalisée sur la portion de matériau organique, et la première ouverture étant réalisée telle qu'elle traverse la première couche de matériau getter et la deuxième couche de matériau getter ;
- gravure de la portion de matériau organique à travers la première ouverture et, lorsque la première structure getter comporte la troisième couche de matériau getter, également à travers la deuxième ouverture ;
- bouchage par dépôt d'au moins une couche de bouchage sur la deuxième couche de matériau getter au moins au niveau de la première ouverture ou, lorsque la première structure getter comporte la troisième couche de matériau getter, sur la troisième couche de matériau getter au moins au niveau de la deuxième ouverture.

Le procédé d'encapsulation peut comporter en outre, préalablement à la réalisation de la portion de matériau organique, la mise en œuvre d'un procédé de réalisation d'une deuxième structure getter tel que défini précédemment et tel que le support de la deuxième structure getter soit formé par le substrat, et dans lequel la portion de matériau organique est réalisée en recouvrant la deuxième structure getter.

Enfin, l'invention concerne également un procédé d'encapsulation d'au moins un micro-dispositif disposé sur et/ou dans un substrat, comportant au moins les étapes suivantes :
- mise en œuvre d'un procédé de réalisation d'une structure getter tel que défini précédemment et tel que le support de la structure getter soit formé par le substrat ;
- réalisation d'une portion de matériau organique sur le substrat et recouvrant au moins le micro-dispositif et la structure getter ;
- dépôt d'au moins une couche capot recouvrant la portion de matériau organique ;
- réalisation d'au moins une ouverture à travers la couche capot ;
- gravure de la portion de matériau organique à travers l'ouverture ;
- dépôt d'au moins une couche de bouchage recouvrant la couche capot au moins au niveau de l'ouverture.

La couche de bouchage peut comporter au moins un matériau getter.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent respectivement une vue de dessus et une vue en coupe de côté d'une structure getter, objet de la présente invention, selon un premier mode de réalisation ;
- la figure 3 représente une vue en coupe d'une structure getter, objet de la présente invention, selon un deuxième mode de réalisation ;
- les figures 4 et 5 représentent respectivement une vue de dessus et une vue en coupe de côté d'une structure getter, objet de la présente invention, selon une première variante du premier mode de réalisation ;
- les figures 6 et 7 représentent des vues de dessus d'une structure getter, objet de la présente invention, selon des deuxième et troisième variantes du premier mode de réalisation ;
- les figures 8 à 14 représentent des vues en coupe de côté de plusieurs structures d'encapsulation, objets de la présente invention, selon différents exemples de réalisation ;
- la figure 15 représente une vue en coupe de côté d'une structure getter, objet de la présente invention, selon une variante du premier mode de réalisation ;
- la figure 16 représente une vue en coupe de côté d'une structure getter, objet de la présente invention, selon une variante du premier mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

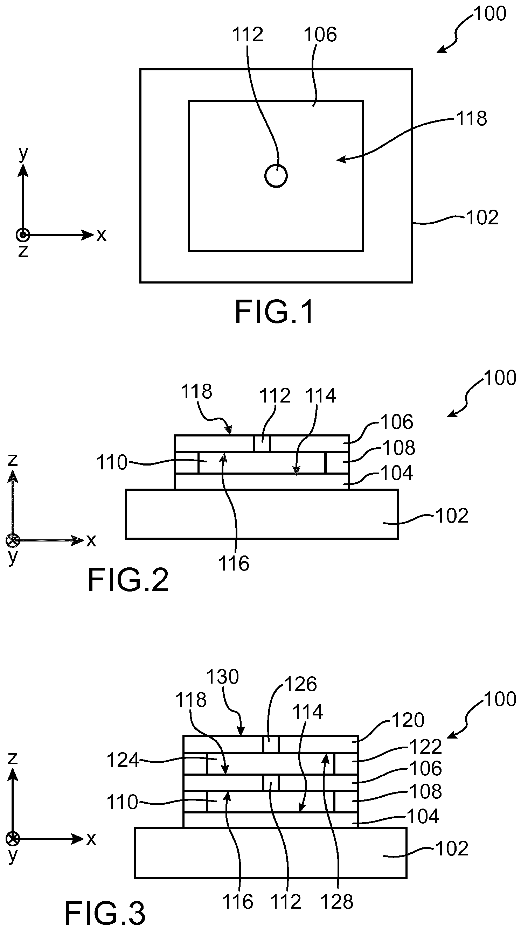

Les figures 1 et 2 représentent respectivement une vue de dessus et une vue en coupe de côté d'une structure getter 100 selon un premier mode de réalisation.

La structure getter 100 comporte un support 102 correspondant ici à un substrat par exemple en semi-conducteur. La structure getter 100 comporte une première couche 104 de matériau getter disposée sur le support 102, ainsi qu'une deuxième couche 106 de matériau getter telle que la première couche 104 soit disposée entre le support 102 et la deuxième couche 106. Les couches 104 et 106 ont ici des dimensions (hauteurs, longueurs et largeurs) et des formes sensiblement similaires. La deuxième couche 106 est supportée mécaniquement par une ou plusieurs premières portions 108 de matériau formées sur la première couche 104 et espaçant les couches 104 et 106 l'une de l'autre en formant un premier espace 110 entre ces couches 104 et 106. Sur l'exemple des figures 1 et 2, une seule première portion 108 est disposée entre les couches 104 et 106, au niveau de la périphérie de ces couches 104, 106. La deuxième couche 106 est traversée par une ou plusieurs premières ouvertures 112 (une seule sur l'exemple des figures 1 et 2) faisant communiquer le premier espace 110 avec l'environnement extérieur de la structure getter 100.

Les couches 104 et 106 comportent avantageusement du titane et/ou du zirconium et/ou du vanadium, ou un de leur alliage. De façon générale, les couches de matériaux getter peuvent comporter tout matériau getter de type NEG, par exemple comprenant au moins l'un de ces deux métaux, et qui peuvent être par exemple déposés par PVD.

La première portion 108 comporte par exemple un matériau métallique, comprenant de préférence du Ru et/ou du Cr et/ou du Cu et/ou du Ni et/ou de l'Al et/ou de l'Au. De plus, du fait que la première portion 108 est issue d'une couche de matériau sacrificiel initialement présente entre les couches 104 et 106, le matériau de la première portion 108 est avantageusement un matériau pouvant être gravé sélectivement vis-à-vis des matériaux getter des couches 104 et 106 (les matériaux getter étant dans ce cas peu sensibles à la gravure du matériau sacrificiel, et réciproquement). A titre d'exemple, lorsque les couches 104 et 106 comportent du titane (qui peut être gravé avantageusement par voie sèche), la première portion 108 peut être issue d'une couche de matériau sacrificiel comportant du Cu et/ou de l'Al et/ou du Cr, qui sont des matériaux pouvant être gravés sélectivement vis-à-vis du titane, avantageusement par voie humide.

Les couches 104 et 106 ont par exemple chacune une épaisseur (dimension selon l'axe Z sur les figures 1 et 2) comprise entre environ 100 nm et 2 µm. L'épaisseur de la première portion 108, qui correspond à l'épaisseur de la couche de matériau sacrificiel dont est issue la première portion 108, peut être comprise entre environ 20 nm et 2 µm. Lorsque le matériau sacrificiel peut être déposé selon un procédé électrolytique, son épaisseur peut être inférieure ou égale à environ 10 µm.

En contact avec des espèces gazeuses, une telle structure getter 100 réalise donc une absorption et/ou une adsorption de gaz depuis :
- une première face 114 de la première couche 104 qui est exposée dans le premier espace 110 ;
- une première face 116 de la deuxième couche 106 qui est exposée dans le premier espace 110 ;
- une deuxième face 118 de la deuxième couche 106 qui est opposée à la première face 116 et qui forme ici la face supérieure de la structure getter 100.

Dans une moindre mesure, l'absorption et/ou l'adsorption gazeuse est également réalisée par les faces latérales (celles sensiblement perpendiculaires aux faces 114, 116 et 118) des couches 104 et 106 ainsi que par les parois latérales de la première ouverture 112.

Ainsi, par rapport à une structure getter qui serait formée d'une seule couche de matériau getter disposée sur le support 102 (par exemple uniquement de la première couche 104) et qui réaliserait donc une absorption et/ou une adsorption de gaz uniquement par sa face supérieure opposée à celle en contact avec le support 102, la structure getter 100 selon ce premier mode de réalisation permet de réaliser une absorption et/ou une adsorption de gaz environ trois fois plus importante grâce aux trois faces 114, 116 et 118 exposées.

La première ouverture 112 permet d'exposer les faces 114 et 116 des couches 104 et 106 à l'environnement extérieur à la structure getter 100. De manière générale, la structure getter 100 peut comporter une ou plusieurs premières ouvertures 112 traversant la deuxième couche 106. La structure getter 100 peut notamment comporter plusieurs premières ouvertures 112 localisées en différents endroits de la deuxième couche 106. Ces premières ouvertures peuvent en outre être de tailles et/ou de formes différentes. Afin que la deuxième couche 106 garde une bonne capacité d'absorption et/ou d'adsorption de gaz, la ou les premières ouvertures 112 sont réalisées de préférence telles que la surface occupée par cette ou ces premières ouvertures 112 au niveau des faces 116 et 118 soit inférieure ou égale à environ 20 % de la surface totale de la face 118 (la surface totale d'une face correspondant à la somme de la surface de matériau getter au niveau de cette face et de la surface de vide formée par la ou les premières ouvertures 112 au niveau de cette face).

Outre le rôle de mise en communication du premier espace 110 avec l'environnement extérieur à la structure getter 100, la ou les premières ouvertures 112 servent également, lors de la réalisation de la structure getter 100, à former des accès à une première couche de matériau sacrificiel disposée entre les couches 104 et 106 afin de graver partiellement cette première couche de matériau sacrificiel, une ou des portions restantes de cette première couche de matériau sacrificiel correspondant à la ou aux premières portions 108.

La ou les premières ouvertures 112 sont avantageusement réalisées, en termes de formes, de dimensions et d'emplacements dans la deuxième couche 106, telles qu'il soit possible de bien contrôler la structure des portions restantes de la première couche de matériau sacrificiel formant la ou les premières portions 108, et/ou de faciliter la gravure de la première couche de matériau sacrificiel. Cette gravure est réalisée de préférence telle que la partie de la surface de la face 116 de la deuxième couche 106 qui est en contact avec la ou les premières portions 108 corresponde à environ 20 % ou moins de la surface totale de la face 118. Cette même proportion se retrouve également pour la face 114 de la première couche 104. Toutefois, la ou les premières portions 108 présentent une surface de contact suffisante avec les couches 104 et 106 pour assurer une bonne stabilité mécanique de la structure getter 100.

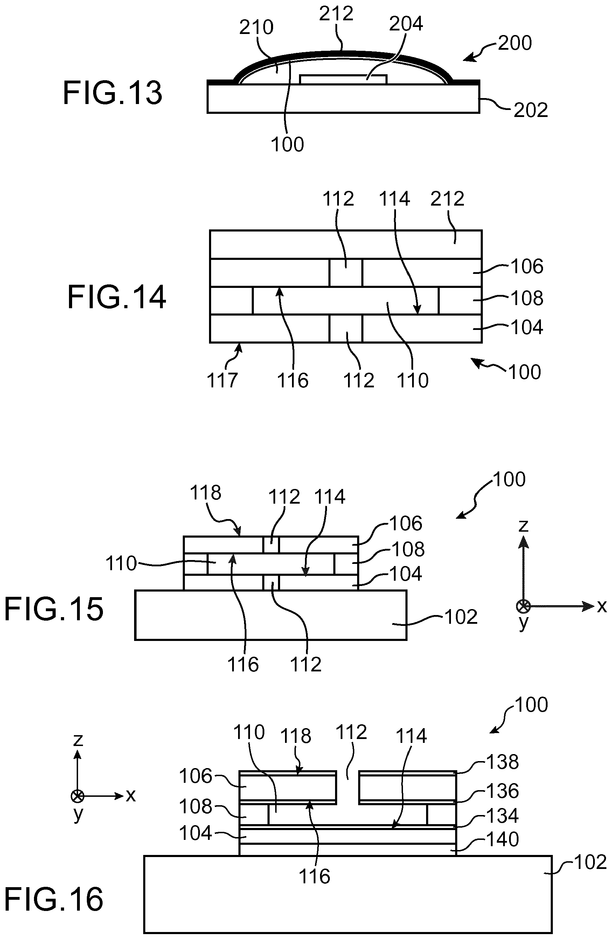

La figure 15 représente une vue en coupe de la structure getter 100 selon une variante du premier mode de réalisation précédemment décrit.

Par rapport à la structure getter 100 précédemment décrite en liaison avec les figures 1 et 2, cette structure getter 100 selon cette variante diffère du fait que la ou les premières ouvertures 112 traversent également au moins une partie de la première couche 104. Sur l'exemple de la figure 15, l'ouverture 112 traverse la deuxième couche 106 ainsi que toute l'épaisseur de la première couche 104. Une telle ouverture 112 est avantageusement réalisée par une gravure RIE à travers les deux couches 104 et 106. Une telle variante peut notamment être réalisée lorsque les matériaux des couches 104 et 106 ne peuvent pas être gravés sélectivement l'un par rapport à l'autre, par exemple dans le cas d'un même matériau getter utilisé pour former les couches 104 et 106.

La figure 16 représente une vue en coupe de la structure getter 100 selon une autre variante du premier mode de réalisation précédemment décrit.

Par rapport à la structure getter 100 précédemment décrite en liaison avec les figures 1 et 2, cette structure getter 100 selon cette variante comporte des couches de protection 134, 136 et 138 protégeant respectivement les faces 114, 116 et 118 des couches de matériau getter 104 et 106. Les couches de protection 136, 138 sont traversées par l'ouverture 112. Ces couches de protection 134, 136, 138 permettent notamment de protéger les couches 104, 106 des agressions chimiques qui sont susceptibles d'avoir lieu pendant et/ou postérieurement à la réalisation de la structure getter 100, sans altérer la capacité de pompage des matériaux getter des couches 104, 106. Par exemple, lorsque la première portion 108 est formée en gravant une couche de matériau sacrificiel initialement disposée entre les couches 104 et 106, la gravure mise en œuvre est généralement une gravure par plasmas oxydants qui peuvent contribuer à réduire la capacité de pompage des matériaux getter en l'absence de protection des matériaux getter, en raison des oxydes se formant en surface des matériaux getter. Lorsque la première portion 108 est formée par gravure d'une couche sacrificielle initialement disposée entre les couches 104 et 106, ces couches de protection 134, 136, 138 comportent un ou plusieurs matériaux différents de celui ou ceux de la couche sacrificielle afin que ces couches de protection ne soient pas affectées par la gravure mise en œuvre pour former la première portion 108. Par exemple, les matériaux des couches de protection 134, 136, 138 peuvent comporter de l'Au et/ou du Cr et/ou un oxyde de l'alliage ou du métal formant le matériau getter contre lequel la couche de protection est réalisée et/ou un nitrure de l'alliage ou du métal formant le matériau getter contre lequel la couche de protection est réalisée. En outre, les épaisseurs des couches de protection 134, 136 et 138 peuvent être chacune comprise entre quelques nanomètres et quelques dizaines de nanomètres, par exemple inférieure à environ 100 nm ou inférieure à environ 50 nm.

Bien que sur la figure 16 les trois faces 114, 116 et 118 sont chacune protégées par une des couches de protection 134, 136, 138, il est possible qu'une seule ou deux de ces faces 114, 116, 118 soient protégées par une ou deux de ces couches de protection 134, 136, 138.

Une sous-couche d'ajustement 140 apte à réguler la température d'activation thermique du matériau getter de la première couche 104 est disposée sous la première couche 104 de matériau getter, entre le support 102 et la première couche 104. Une telle sous-couche d'ajustement 140 ne sert pas de couche de matériau sacrificiel. Cette sous-couche d'ajustement 140 peut être une couche métallique comportant un ou plusieurs des matériaux suivants : Ru, Cr, Ni, Cu, Al, Au, et Pt. Des détails de réalisation d'une telle sous-couche d'ajustement sont donnés dans le document FR 2 922 202.

En variante, la couche 138 peut correspondre non pas à une couche de protection telle que précédemment décrite, mais à une couche réflectrice formant la face avant de la structure getter et apte à réfléchir un rayonnement infrarouge reçu par la structure getter 100 au niveau de cette face avant.

La figure 3 représente une vue de dessus de la structure getter 100 selon un deuxième mode de réalisation.

La structure getter 100 selon ce deuxième mode de réalisation comporte tous les éléments précédemment décrits pour le premier mode de réalisation.

Elle comporte également une troisième couche de matériau getter 120 telle que la deuxième couche 106 soit disposée entre la première couche 104 et la troisième couche 120. La troisième couche 120 est par exemple similaire (en termes de dimensions, forme et nature du matériau getter) à la deuxième couche 106. Cette troisième couche 120 est supportée mécaniquement par une ou plusieurs deuxièmes portions 122 de matériau formées sur la face 118 de la deuxième couche 106 et qui espacent les couches 106 et 120 l'une de l'autre en formant un deuxième espace 124 entre ces couches 106 et 120. Sur l'exemple de la figure 3, une seule deuxième portion 122 (ici similaire à la première portion 108 en termes de forme, dimensions et nature de matériau) est disposée entre les couches 106 et 120, au niveau de la périphérie de ces couches. La troisième couche 120 est traversée par une ou plusieurs deuxièmes ouvertures 126 (une seule sur l'exemple de la figure 3) faisant communiquer le deuxième espace 124 avec l'environnement extérieur de la structure getter 100.

En contact avec des espèces gazeuses, une telle structure getter 100 réalise donc une absorption et/ou une adsorption de gaz depuis :
- la première face 114 de la première couche 104 qui est exposée dans le premier espace 110 ;
- la première face 116 de la deuxième couche 106 qui est exposée dans le premier espace 110 ;
- la deuxième face 118 de la deuxième couche 106 qui est exposée dans le deuxième espace 124 ;
- une première face 128 de la troisième couche 120 qui est exposée dans le deuxième espace 124 ;
- une deuxième face 130 de la troisième couche 120 qui est opposée à la première face 128 et qui forme ici la face supérieure de la structure getter 100.

Dans une moindre mesure, l'absorption/adsorption de gaz est également réalisée par les faces latérales (sensiblement perpendiculaires aux faces 114, 116, 118, 128, 130) des couches 104, 106 et 120 ainsi que par les parois latérales des ouvertures 112 et 126.

Ainsi, par rapport à une structure getter qui serait formée d'une seule couche de matériau getter disposée sur le support 102 et qui réaliserait donc une absorption et/ou une adsorption de gaz uniquement par sa face supérieure, la structure getter 100 selon ce deuxième mode de réalisation permet de réaliser une absorption et/ou une adsorption de gaz environ cinq fois plus importante grâce aux cinq faces 114, 116, 118, 128 et 130 exposées.

De manière générale, la structure getter 100 selon ce deuxième mode de réalisation peut comporter une ou plusieurs deuxièmes ouvertures 126 traversant la troisième couche 120. La structure getter 100 peut notamment comporter plusieurs deuxièmes ouvertures 126 localisées en différents endroits de la troisième couche 120. Ces deuxièmes ouvertures 126 peuvent en outre être de tailles et/ou de formes différentes. Afin que la troisième couche 120 garde une bonne capacité d'absorption et/ou d'adsorption, la ou les deuxièmes ouvertures 126 sont réalisées de préférence telles que la surface occupée par cette ou ces deuxièmes ouvertures 126 au niveau des faces 128 et 130 soit inférieure ou égale à environ 20 % de la surface totale de la face 130.

Outre le rôle de mise en communication des espaces 110 et 124 avec l'environnement extérieur à la structure getter 100, la ou les deuxièmes ouvertures 126 servent également, lors de la réalisation de la structure getter 100, à former des accès à la première couche de matériau sacrificiel disposée entre les couches 104 et 106 (via la ou les premières ouvertures 112) et à une deuxième couche de matériau sacrificiel disposée entre les couches 106 et 120, afin de graver partiellement les première et deuxième couches de matériau sacrificiel. La ou les portions restantes de la première couche de matériau sacrificiel correspondent à la ou aux premières portions 108, et la ou les portions restantes de la deuxième couche de matériau sacrificiel correspondent à la ou aux deuxièmes portions 122.

La ou les deuxièmes ouvertures 126 sont avantageusement réalisées, en termes de formes, de dimensions et d'emplacements dans la troisième couche 120, telles qu'il soit possible de bien contrôler la structure des portions restantes de la deuxième couche de matériau sacrificiel formant la ou les deuxièmes portions 122, et/ou de faciliter la gravure de la deuxième couche de matériau sacrificiel. Cette gravure est réalisée de préférence telle que la partie de la surface de la face 128 de la troisième couche 120 qui est en contact avec la ou les deuxièmes portions 122 corresponde à environ 20 % ou moins de la surface totale de la face 130. Cette même proportion se retrouve également pour la face 118 de la deuxième couche 106. Toutefois, la ou les deuxièmes portions 122, et la ou les premières portions 108, présentent une surface de contact suffisante avec les différentes couches de matériau getter pour assurer une bonne stabilité mécanique de l'ensemble de la structure getter 100.

Comme précédemment décrit pour la figure 15, la ou les premières ouvertures 112 peuvent également traverser au moins une partie de l'épaisseur de la première couche 104.

Comme précédemment décrit pour la figure 16, une ou plusieurs des faces 114, 116, 118, 128, 130 des couches 104, 106 et 120 peuvent être protégées par des couches de protection analogues aux couches 134, 136, 138 précédemment décrites.

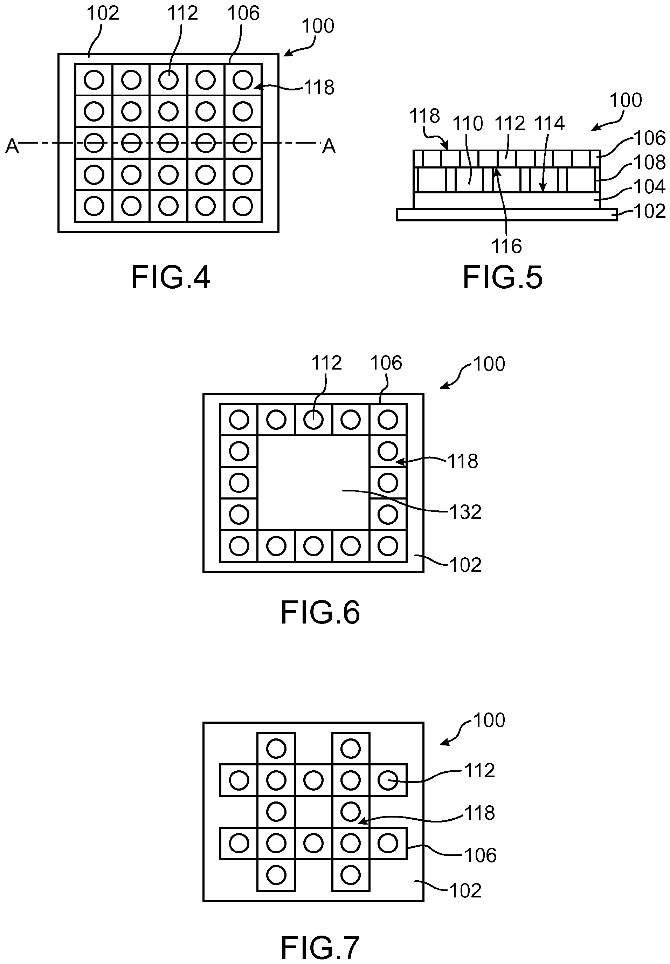

Les figures 4 et 5 représentent respectivement une vue de dessus et une vue en coupe d'une structure getter 100 selon une première variante du premier mode de réalisation. La figure 5 est une vue en coupe selon l'axe AA visible sur la figure 4.

Dans cette première variante, la structure getter 100 comporte plusieurs premières ouvertures 112 régulièrement réparties dans la deuxième couche 106 (au nombre de 25 sur cet exemple). Sur la figure 4, la deuxième couche 106 est représentée symboliquement comme une matrice de portions rectangulaires disposées les unes à côté des autres en formant 5 lignes et 5 colonnes, et chacune traversée en son centre par une des premières ouvertures 112. De plus, plusieurs premières portions 108 sont disposées dans le premier espace 110 entre les couches 104 et 106. La première couche 104 peut également être vue comme une matrice de 25 portions rectangulaires disposées les unes à côté des autres, comme pour la deuxième couche 106, ces portions n'étant pas traversées par des ouvertures.

En considérant « Co » comme correspondant à la capacité totale de pompage, ou capacité d'absorption et/ou d'adsorption, de gaz de la première couche 104 disposée sur le support 102, la capacité de pompage de chacune des 25 portions rectangulaires de la deuxième couche 106 (qui est de dimensions, de forme et de nature similaires à la première couche 104) est égale à environ Co/25. Ainsi, la capacité de pompage de la structure getter 100 représentée sur les figures 4 et 5 est égale à environ 25^{∗}3^{∗}Co/25 = 3^{∗}Co (le facteur 3 est obtenu en raison de l'exposition des trois faces 114, 116 et 118 des couches 104 et 106). En toute rigueur, s'il est tenu compte des parties des surfaces de matériau getter perdues aux emplacements des premières ouvertures 112 et des portions 108, la capacité de pompage de la structure getter 100 est inférieure à celle indiquée ci-dessus. Par exemple, en considérant que chacune des portions rectangulaires formant les couches 104 et 106 a une forme carrée de surface So égale à 100 µm² (surface So d'une face principale d'une des portions), c'est-à-dire ayant des côtés de dimension égale à 10 µm chacun, et comporte une première ouverture 112 et des portions 108 occupant environ 10 % de la surface totale So de cette portion, la capacité totale de pompage de la structure getter 100 est alors égale à environ 2,6^{∗}Co. En tenant compte de la surface de matériau getter développée autour de chaque ouverture 112, le gain de surface de matériau getter est d'environ e^{∗}So^{0,5}, où e représente l'épaisseur de la couche 106. Pour une surface So égale à 100 µm² et une épaisseur e égale à 1 µm, le gain de surface est de l'ordre de 10 µm², soit au total une capacité de pompage d'environ 2,7^{∗}Co.

La figure 6 représente une vue de dessus d'une structure getter 100 selon une deuxième variante du premier mode de réalisation.

Dans cette deuxième variante, les couches 104 et 106 ont chacune une section, dans un plan parallèle aux faces 118, 116 et 114, en forme de cadre rectangulaire. Chacune des couches 104 et 106 peut donc être représentée symboliquement comme correspondant à des portions rectangulaires (au nombre de 16 sur l'exemple de la figure 6) agencées autour d'un espace vide 132 (occupant un volume égal à celui de 9 portions rectangulaires chacune de dimensions similaires à celles de l'une des 16 portions de chacune des couches 104 et 106).

En considérant la capacité de pompage Co précédemment définie pour l'exemple représenté sur les figures 4 et 5, la capacité de pompage de la structure getter 100 représentée sur la figure 6 est égale à environ 16^{∗}3^{∗}Co/25 = 1,92^{∗}Co. En considérant la surface occupée par les ouvertures 112 et les portions 108 comme précédemment décrit pour l'exemple des figures 4 et 5, la capacité de pompage de la structure getter 100 représentée sur la figure 6 est égale à environ 16^{∗}2,7^{∗}Co/25 = 1,73^{∗}Co.

La figure 7 représente une vue de dessus d'une structure getter 100 selon une troisième variante du premier mode de réalisation.

Dans ce troisième exemple de réalisation, les couches 104 et 106 ont chacune une section, dans un plan parallèle aux faces 118, 116 et 114, en forme de grille. Chacune des couches 104 et 106 peut donc être représentée symboliquement comme correspondant à des portions rectangulaires (au nombre de 16 sur l'exemple de la figure 7) agencées en plusieurs lignes et plusieurs colonnes espacées les unes des autres et se croisant.

En considérant la capacité de pompage Co précédemment définie pour le premier exemple représenté sur les figures 4 et 5, la capacité de pompage de la structure getter 100 représentée sur la figure 7 est égale à environ 16^{∗}3^{∗}Co/25 = 1,92^{∗}Co, ou plus précisément égale à 16^{∗}2,7^{∗}Co/25 = 1,73^{∗}Co en reprenant l'exemple précédemment décrit.

Les variantes des figures 6 et 7 permettent notamment de dégager des zones du support 102 sur lesquelles il n'est pas possible de déposer du matériau getter, par exemple sur des zones au niveau desquelles des fonctions optiques sont destinées à être réalisées.

Ces variantes peuvent s'appliquer également au deuxième mode de réalisation précédemment décrit en liaison avec la figure 3. Dans ce cas, la troisième couche 120 a par exemple une forme et des dimensions similaires à celles des couches 104 et 106.

D'autres variantes sont envisageables, dans lesquelles les couches de matériau getter de la structure getter 100 auraient des formes différentes de celles précédemment décrites. De plus, il est également possible que les différentes couches de matériau getter de la structure getter 100 comportent des matériaux getter différents.

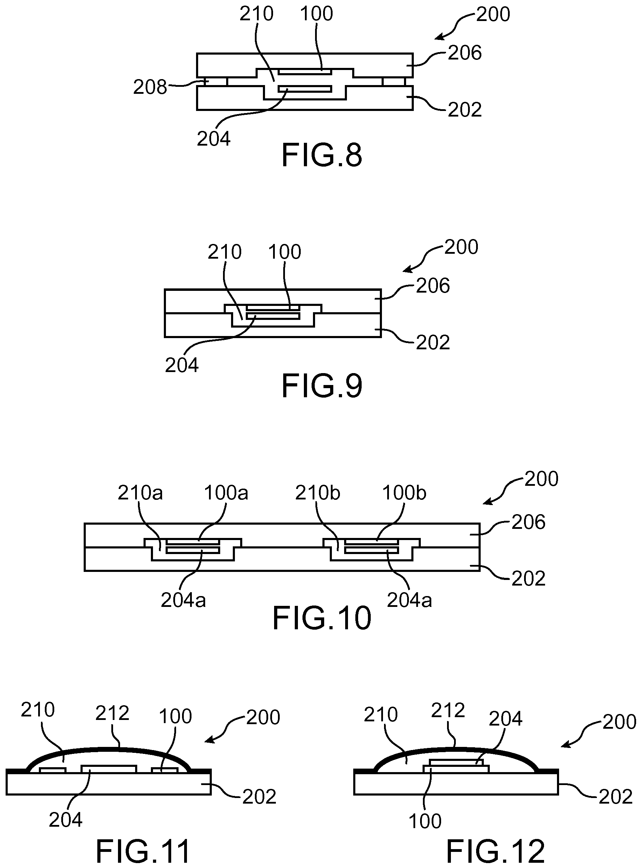

La figure 8 représente une vue en coupe de côté d'une structure d'encapsulation 200 selon un premier exemple de réalisation.

La structure 200 comporte un premier substrat 202, par exemple en semi-conducteur tel que du silicium, dans lequel est réalisé un micro-dispositif 204, par exemple de type MEMS. Le capot de la structure 200 est formé par un deuxième substrat 206, par exemple également en silicium, solidarisé au premier substrat 202 par l'intermédiaire d'un cordon de scellement 208, ou interface de collage. Le micro-dispositif 204 est encapsulé dans une cavité 210 formée entre les deux substrats 202, 206 et qui est délimitée latéralement par le cordon 208.

Une structure getter 100 correspondant à l'une des structures getter précédemment décrites est disposée sur la paroi supérieure de la cavité 210, sur le deuxième substrat 206. Le deuxième substrat 206 correspond donc au support de la structure getter 100.

La structure getter 100 permet donc de réaliser une absorption et/ou une adsorption de gaz présents dans la cavité 210 après le scellement des deux substrats 202, 206 par l'intermédiaire du cordon 208.

La figure 9 représente une vue en coupe de côté d'une structure d'encapsulation 200 selon un deuxième exemple de réalisation.

Par rapport à la structure 200 précédemment décrite en liaison avec la figure 8, l'assemblage entre les deux substrats 202, 206 est réalisé par un procédé de scellement direct Si/Si ou SiO₂/SiO₂ ou métal/métal (en fonction de la nature des matériaux présents à l'interface entre les substrats 202, 206), également appelé « Direct Bonding ». Il est également possible que le deuxième substrat 206 soit en verre et que le premier substrat 202 soit en silicium, l'assemblage étant dans ce cas réalisé par scellement anodique.

La figure 10 représente une variante de la structure d'encapsulation 200 de la figure 9. Dans cette structure d'encapsulation, deux micro-dispositifs 204a, 204b sont encapsulés dans deux cavités distinctes 210a, 210b et sous des atmosphères différentes. Ces atmosphères différentes sont obtenues grâce au fait que les structures getter 100a, 100b ont des capacités d'absorption et/ou d'adsorption différentes. Ces capacités différentes des structures getter 100a, 100b peuvent être obtenues du fait que les dimensions et/ou les formes des couches de matériau getter sont différentes d'une structure getter à l'autre, et/ou que les matériaux getter sont différents d'une structure getter à l'autre. Il est également possible d'obtenir des capacités d'absorption et/ou d'adsorption différentes à partir de couches de matériau getter similaires d'une structure getter à l'autre, mais en réalisant des première ouvertures 112 (et éventuellement des deuxièmes ouvertures 126) différentes (en termes de forme et/ou de nombre et/ou de dimensions) d'une structure getter à l'autre. On peut ainsi moduler la capacité de pompage d'une structure getter avec un facteur compris entre environ 1 et 3 lorsque la structure getter est réalisée à partir de deux couches de matériau getter et une couche de matériau sacrificiel.

Un nombre plus important de cavités et de micro-dispositifs peut être envisagé que sur l'exemple de la figure 10. De plus, cette variante peut être appliquée à la structure d'encapsulation 200 représentée sur la figure 8.

Dans les exemples de réalisation des figures 8 à 10, la ou les structures getter 100 sont disposées sur le deuxième substrat 206 formant le capot de la structure d'encapsulation. En variante, il est possible que la ou les structures getter 100 soient disposées sur le premier substrat 202 au niveau duquel se trouve le micro-dispositif 204. Selon une autre variante, la structure d'encapsulation 200 peut comporter à la fois une ou plusieurs structures getter 100 disposées sur le deuxième substrat 206 et une ou plusieurs structures getter 100 disposées sur le premier substrat 202.

La figure 11 représente la structure d'encapsulation 200 selon un troisième exemple de réalisation.

Contrairement aux précédents exemples de réalisation des figures 8 à 10, le capot de la structure d'encapsulation 200 n'est pas formée par le deuxième substrat 206 mais par une ou plusieurs couches minces 212, ou couches capot, formées lors d'un procédé d'encapsulation de type PCM (c'est-à-dire en ayant formé tout d'abord une portion de matériau organique dont le volume correspond au volume de la cavité 210 souhaitée sur le substrat 202, puis en recouvrant cette portion de matériau organique de la ou des couches minces 212 destinées à former le capot de la structure 200, puis en gravant la portion de matériau organique à travers au moins une ouverture réalisée dans cette ou ces couches minces). Dans cette structure d'encapsulation 200, la structure getter 100 est disposée sur le substrat 202 et est réalisée telle qu'elle entoure le micro-dispositif 204. La structure getter 100 a par exemple une forme de cadre comme dans l'exemple précédemment décrit en liaison avec la figure 6.

Le nombre de couches minces 212 ainsi que le ou les matériaux de cette ou de ces couches 212 et leur(s) épaisseur(s) sont fonction du niveau d'herméticité et de la tenue mécanique recherchés. L'épaisseur totale des couches 212 formant le capot peut être comprise entre environ 2 µm et 30 µm. Ces couches peuvent comporter des matériaux différents selon les propriétés recherchées pour ces couches et l'atmosphère recherchée dans la cavité 210 après sa fermeture hermétique. Par exemple, tous types de matériaux pouvant être déposés par PVD peuvent être utilisés pour former les couches 212 du capot (nitrure ou oxyde de semi-conducteur, métal, getter, etc.).

La figure 12 représente la structure d'encapsulation 200 selon un quatrième exemple de réalisation. Par rapport au troisième exemple de la figure 11, la structure getter 100 n'est pas réalisée telle qu'elle entoure le micro-dispositif 204, mais est disposée entièrement ou en partie sous le micro-dispositif 204. Une telle configuration est avantageuse par exemple lorsque le micro-dispositif 204 correspond à un micro-bolomètre, la structure getter 100 servant également de réflecteur au rayonnement infrarouge reçu. Dans ce quatrième mode de réalisation, la structure getter 100 comporte avantageusement deux couches de matériaux getter, par exemple similaires aux couches 104 et 106 dont la face supérieure 114 de la première couche 104 est recouverte par la couche de protection 134 et dont la face inférieure 116 de la deuxième couche 106 est recouverte par la couche de protection 136. La face supérieure 118 de la deuxième couche 106 peut être recouverte d'une couche réflectrice apte à réfléchir le rayonnement infrarouge. Dans une telle structure getter 100, la ou les ouvertures 112 peuvent avoir un diamètre tel que le ou les matériaux déposés sur la structure getter (par exemple du polymère) lors de la réalisation de la structure d'encapsulation 200 ne pénètre pas dans l'espace 110, évitant ainsi tout contact entre le ou les matériaux déposés et le matériau getter exposé dans cet espace 110. De manière avantageuse, ce diamètre peut être compris entre 1 et quelques microns.

La figure 13 représente la structure d'encapsulation 200 selon un cinquième exemple de réalisation.

Dans cette structure d'encapsulation 200, la structure getter 100 fait partie du capot et est disposée contre la ou les couches minces 212 en formant une paroi intérieure de la cavité 210. La figure 14 représente une vue plus détaillée d'une partie du capot ainsi formé.

Les éléments de la structure getter 100 représentée sur la figure 14 correspondent à ceux de la structure getter 100 précédemment décrite en liaison avec les figures 1 et 2. La deuxième couche 106 de la structure getter 100 est disposée contre la ou les couches minces 212. Les faces 114 et 116 des couches de matériau getter 104, 106 sont exposées à l'atmosphère de la cavité 210 par la ou les premières ouvertures 112. La face 117 de la première couche 104 forme la paroi intérieure de la cavité 110.

De manière avantageuse, une couche de protection est déposée sur le matériau sacrificiel servant à la réalisation de la cavité 210 afin d'éviter un contact direct entre la première couche 104 de matériau getter et le matériau sacrificiel.

La ou les premières ouvertures 112 sont formées à travers les première et deuxième couches 104 et 106. Ainsi, lors de la réalisation de la structure d'encapsulation 200, il est possible de graver la portion de matériau organique sur laquelle la structure getter 100 et la ou les couches minces 212 sont réalisées (une description détaillée de ce procédé de réalisation est donnée plus loin). Sur la figure 14, les ouvertures 112 formées dans les couches 104 et 106 sont superposées et alignées l'une par rapport à l'autre. En variante, il est possible que la ou les ouvertures 112 traversant la couche 104 ne soient pas superposées et alignées avec la ou les ouvertures 112 traversant la couche 106. Ainsi, dans le cas où la réalisation de la ou des couches 212 peut entraîner un dépôt de matériau à travers la ou les ouvertures 112 de la couche 106, ce matériau se retrouve déposé sur la face 114 de la couche 104, ce qui évite donc tout risque de dépôt du ou des matériaux de la ou des couches 212 dans la cavité 210 à travers la ou les ouvertures 112 de la couche 104. Cette configuration permet donc d'éviter une pollution éventuelle du dispositif 204 lors du dépôt de la ou des couches de fermeture 212.

Dans l'exemple des figures 13 et 14, il est considéré que la première couche 104 de la structure getter 100 correspond à la couche formant la paroi intérieure de la cavité 210 car lors de la réalisation de la structure getter, la première couche 104 est la première couche déposée sur la portion de matériau organique. Toutefois, il est possible de considérer que la couche de matériau en contact avec la ou les couches minces 212 (la deuxième couche 106 sur les figures 13 et 14) correspond en fait à la première couche 104 et que la couche de matériau getter formant la paroi intérieure de la cavité 210 correspond à la deuxième couche 106 (ou la troisième 120 si la structure getter 100 comporte cette troisième couche 120).

Dans tous les modes, variantes et exemples de réalisation précédemment décrits, chaque structure getter peut comporter des couches d'un même matériau getter, ou bien des couches de matériaux getter différents. En réalisant la structure getter à partir de différents matériaux getter, il est donc possible de combiner au sein de la structure getter des matériaux getter ayant des propriétés d'absorption et/ou d'adsorption différentes, ce qui permet par exemple à une telle structure getter de piéger sélectivement des espèces gazeuses différentes en fonction des matériaux getter utilisés, et donc de mieux contrôler l'atmosphère résiduelle dans laquelle se trouve la structure getter. Outre les propriétés d'absorption et/ou d'adsorption différentes entre deux matériaux getter différents, il est également possible d'utiliser avantageusement leur différence d'aptitude à la gravure. En effet, pour les deux variantes de la structure 100 des figures 2 et 3, le matériau de la couche 104 peut être du zirconium, et celui de la ou des autres couches de matériau getter (106 et éventuellement 120) peut être du titane. Le titane peut être mis en forme par gravure RIE, le zirconium résistant à ce type de gravure. Les ouvertures 112 sont dans ce cas localisées uniquement dans les couches de titane, sans réduire la surface de matériau getter formée par le zirconium, c'est-à-dire la surface de matériau getter de la couche 104.

Un exemple de procédé de réalisation de la structure d'encapsulation 200 précédemment décrite en liaison avec la figure 8 ou 9 est décrit ci-dessous.

Le micro-dispositif 204 est tout d'abord réalisé sur et/ou dans le premier substrat 202.

Parallèlement, la structure getter 100 est réalisée sur le deuxième substrat 206. La première couche 104 de matériau getter est tout d'abord déposée sur le deuxième substrat 206. Une couche de matériau sacrificiel, avantageusement apte à être gravé sélectivement par rapport aux matériaux getter des couches 104 et 106, est ensuite réalisée sur la première couche 104. La deuxième couche 106 de matériau getter est ensuite déposée sur la couche de matériau sacrificiel. Lorsque la structure getter 100 comporte plus de deux couches de matériau getter, comme sur l'exemple de la figure 3, la ou les couches supplémentaires de matériau getter et de matériau sacrificiel sont également déposées telle qu'une couche de matériau sacrificiel soit à chaque fois interposée entre deux couches de matériau getter. Les couches de protection des différentes faces des couches de matériau getter peuvent avantageusement être réalisées entre ces étapes.

Les différentes couches ainsi formées ont par exemple, dans un plan parallèle à la surface du support sur laquelle ces couches sont réalisées (plan parallèle à la face du deuxième substrat 206 sur laquelle la structure getter 100 est réalisée dans le cas décrit ici), des formes et des dimensions similaires. Les couches déposées sont mises en forme par exemple par photolithographie et gravure.

Les dépôts des couches de matériau getter et de la ou des couches de matériau sacrificiel et éventuellement des couches de protection sont réalisés de préférence à la suite les uns des autres dans un même bâti de dépôt afin d'éviter les remises à l'air, et donc une oxydation, des couches déposées. Par exemple, les couches de matériau getter et la ou les couches de matériau sacrificiel peuvent être déposées par évaporation sous un vide de l'ordre de 10⁻⁸ mbar à 10⁻⁶ mbar. Cependant, l'ajout d'au moins une couche de protection, notamment sur la première couche 104 de matériau getter, peut permettre d'interrompre le cycle de dépôt des couches et de passer dans un autre matériel de dépôt même si cela engendre une exposition à l'air ambiant de la structure getter en cours de réalisation.

La ou les premières ouvertures 112 sont ensuite réalisées par photolithographie et gravure par vois sèche (par exemple de type RIE) à travers la deuxième couche 106 et la couche de matériau sacrificiel (et la ou les éventuelles couches de protection). Si la structure getter comporte plus de deux couches de matériau getter, cette gravure est réalisée à travers toutes les couches de l'empilement sauf la première couche 104, et forme ainsi les autres ouvertures à travers les autres couches de matériau getter (deuxièmes ouvertures 126 comme sur l'exemple de la figure 3).

La ou les couches de matériau sacrificiel sont ensuite partiellement gravées, avantageusement par voie humide, à travers la ou les ouvertures formées à travers la ou les couches de matériau getter. Les portions restantes de la ou des couches de matériau sacrificiel forment les portions de matériau interposées entre les couches de matériau getter (première portion 108 dans l'exemple des figures 1 et 2, et première et deuxième portions 108 et 122 dans l'exemple de la figure 3).

Les deux substrats 202 et 206 sont ensuite scellés l'un à l'autre afin de former la cavité 210 dans laquelle le micro-dispositif 204 est encapsulé. Tous les modes de scellement compatibles avec une encapsulation de type W2W peuvent être utilisés : scellement eutectique (par exemple à partir d'un alliage d'AuSn pour former le cordon de scellement 208 et réalisé à une température supérieure ou égale à environ 280°C, ou bien à partir d'un alliage d'AuSi et à une température supérieure ou égale à environ 360°C, ou encore à partir d'un alliage d'AIGe et à une température supérieure ou égale à environ 419°C), avec ou sans procédé de solidification isotherme (également appelé TLPB pour «Transient Liquid Phase Bonding », ou SLID Bonding pour « Solid Liquid InterDiffusion Bonding »), scellement anodique lorsque l'un des substrats 202 ou 206 est en verre, scellement direct comme pour l'exemple de la figure 9 (Si/Si lorsque les substrats 202 et 206 sont en silicium, SiO₂/SiO₂ lorsque des portions de SiO₂ sont formées au préalable sur les substrats 202 et 206, métal/métal lorsque des portions métalliques sont formées au préalable sur les substrats 202 et 206).

L'activation thermique du ou des matériaux getter est réalisée lors de l'opération de scellement des deux substrats 202 et 206 et/ou par un traitement thermique additionnel post scellement.

Un exemple de procédé de réalisation de la structure d'encapsulation 200 précédemment décrite en liaison avec la figure 11 ou 12 est décrit ci-dessous.

Le micro-dispositif 204 est tout d'abord réalisé sur et/ou dans le substrat 202. La ou les structures getter 100 sont ensuite réalisées sur le substrat 202 comme précédemment décrit. Dans le cas de la structure d'encapsulation représentée sur la figure 12, la ou les structures getter 100 destinées à être disposées sous le micro-dispositif 204 sont réalisées préalablement au micro-dispositif 204.

Une portion de matériau organique, par exemple en polymère, tel qu'une résine avantageusement photosensible, recouvrant au moins le micro-dispositif 204 et la structure getter 100 est ensuite réalisée par dépôt et photolithographie (et éventuellement gravure si le matériau organique n'est pas photosensible) sur le substrat 202. Cette portion de matériau organique est réalisée selon la forme et les dimensions souhaitées pour la cavité 210. Un traitement thermique pour une mise en forme par fluage de la portion de matériau organique peut être mis en œuvre. L'épaisseur de la portion de matériau organique peut varier entre environ 2 micron et 50 microns.

La couche capot 212 (ou les couches 212 lorsque le capot est formée par une superposition de différentes couches) est ensuite déposée en recouvrant la portion de matériau organique.

Une ou plusieurs ouvertures sont ensuite réalisées à travers la ou les couches 212, puis la portion de matériau organique est gravée, par exemple par voie sèche en utilisant un plasma oxydant en température par exemple à environ 250°C, à travers cette ou ces ouvertures. La ou les ouvertures ont par exemple, dans le plan de la ou des couches 212, des dimensions (par exemple le diamètre dans le cas d'une ouverture de forme circulaire) comprises entre environ 1 et 10 microns.

Enfin, une couche de bouchage, qui peut correspondre à une couche hermétique recouvrant la couche capot 212 ou bien à une ou plusieurs portions de matériau hermétiques localisées au niveau de la ou des ouvertures traversant le capot, est ensuite formée sur la ou les couches 212. Cette fermeture de la ou des ouvertures peut être réalisée sous une atmosphère particulière (pression, nature des gaz en présence) qui correspond à celle souhaitée dans la cavité 210. La couche de bouchage est avantageusement en métal ou en matériau getter (qui peut être identique au ou à l'un des matériaux getter de la structure getter 100) et qui va permettre de compléter la capacité de pompage de la structure getter 100.

Un exemple de procédé de réalisation de la structure d'encapsulation 200 précédemment décrite en liaison avec les figures 13 et 14 est décrit ci-dessous.

Le micro-dispositif 204 est tout d'abord réalisé sur et/ou dans le substrat 202. Eventuellement, une ou plusieurs structures getter 100 sont réalisées sur le substrat 202 comme précédemment décrit.

Une portion de matériau organique recouvrant au moins le micro-dispositif 204, et éventuellement la ou les structures getter 100 présentes sur le substrat 202, est ensuite réalisée par dépôt et photolithographie (et éventuellement gravure si le matériau organique n'est pas photosensible) sur le substrat 202. Cette portion de matériau organique est mise en forme selon la forme et les dimensions souhaitées pour la cavité 210.

Les différentes couches de la structure getter 100 destinées à faire partie du capot sont ensuite déposées successivement sur la portion de matériau organique. En raison de la nature organique du matériau, il est possible de déposer, préalablement au dépôt des couches de la structure getter 100, une couche minérale ou métallique (par exemple une couche de dioxyde ou de nitrure de silicium déposée par CVD, ou bien une couche métallique déposée par pulvérisation PVD) sur la portion de matériau organique afin d'éviter de polluer les matériaux getter, lors de leur dépôt, par des composés organiques volatiles issus de la portion de matériau organique. Une telle couche de protection, correspondant à une couche de protection épaisse, peut avoir une épaisseur comprise entre environ 200 nm et 1 micron. L'ajout de cette couche de protection épaisse protégeant les matériaux getter a pour contrepartie de recouvrir la surface extérieure de la couche de matériau getter destinée à être exposée dans la cavité (surface 117 sur l'exemple des figures 13 et 14) ce qui réduit la surface totale d'adsorption/absorption de la structure getter 100. Toutefois, une couche de protection plus fine similaires aux couches 134, 136, 138 précédemment décrites et dont l'épaisseur est comprise entre quelques nanomètres et quelques dizaines de nanomètres, n'altère pas la capacité de pompage du matériau getter.

La ou les ouvertures 112 sont ensuite réalisées à travers les couches de la structure getter, et la ou les couches de matériau sacrificiel sont partiellement gravées, comme précédemment décrit. La portion de matériau organique est ensuite supprimée par gravure.

Le bouchage de la ou des ouvertures 112 servant de trous de libération est ensuite réalisé, par exemple par un dépôt PVD, par exemple sous atmosphère contrôlée (en termes de pression et de nature des gaz).

Dans tous les modes, variantes et exemples de réalisation précédemment décrits, la ou chaque couche de matériau sacrificiel disposée entre deux couches de matériau getter peut servir de sous-couche d'ajustement pour réguler la température d'activation thermique de la couche de matériau getter (par exemple la deuxième couche 106 dans l'exemple des figures 1 et 2) se trouvant sur la couche de matériau sacrificiel. Pour cela, la couche de matériau sacrificiel peut être une couche métallique comportant un ou plusieurs des métaux suivants : Ru, Cr, Ni, Cu, Al, et Au. Ainsi, il est possible de régler les températures d'activation thermique des matériaux getter de la structure getter 100 telles que le matériau getter se trouvant sur une telle couche de matériau sacrificiel s'active à plus basse température que le matériau getter se trouvant sous cette couche de matériau sacrificiel. Il est ainsi possible d'ajuster la pression dans la cavité après bouchage selon deux cycles thermiques différents (ou plus de deux cycles si la structure getter comporte plus de deux couches de matériau getter). Une sous-couche d'ajustement peut également être disposée sous la première couche 104 de matériau getter, entre le support et la première couche 104. Une telle sous-couche d'ajustement ne sert pas de couche de matériau sacrificiel. Dans ce cas, cette sous-couche d'ajustement peut être une couche métallique comportant un ou plusieurs des matériaux suivants : Ru, Cr, Ni, Cu, Al, Au, et Pt. Des détails de réalisation de telles sous-couches d'ajustement sont donnés dans le document FR 2 922 202.

En outre, dans tous les modes, variantes et exemples de réalisation précédemment décrits, l'une ou les couches de matériaux getter de la ou de chacune des structures getter peuvent être protégées en formant, autour de et/ou ou sur cette ou chacune de ces couches, une couche de protection obtenue par nitruration et/ou oxydation du matériau getter par de l'oxygène et/ou de l'azote en milieu exempt de vapeur d'eau, comme décrit dans le document FR 2 950 876. Cette oxydation et/ou nitruration peut être réalisée à une température comprise entre environ 80°C et 120°C, sous une pression comprise entre la pression atmosphérique et environ 10⁻² mbar, pendant une durée comprise entre quelques minutes et quelques dizaines de minutes. Les faces extérieures des couches de matériaux getter peuvent ainsi être protégées vis-à-vis de l'atmosphère ambiante ou de toute altération chimique pouvant être provoquée par des gaz extérieurs. Lors du procédé de réalisation de la structure getter, chaque couche de matériau getter peut être protégée en formant la couche de protection juste après le dépôt de la couche de matériau getter. Il est également possible que les couches de matériau getter de la structure getter soient protégées par une même couche de protection globale formée après la gravure de la ou des couches de matériau sacrificiel lors de la réalisation de la structure getter.

## Revendications

1. Structure getter (100) comportant au moins :
- un support (102) ;
- une première couche (104) de matériau getter disposée sur le support (102) ;
- une deuxième couche (106) de matériau getter telle que la première couche (104) de matériau getter soit disposée entre le support (102) et la deuxième couche (106) de matériau getter ;
- une première portion de matériau (108) reliant mécaniquement une première face (116) de la deuxième couche (106) de matériau getter à une première face (114) de la première couche (104) de matériau getter et formant au moins un premier espace (110) entre les premières faces (114, 116) des première et deuxième couches (104, 106) de matériau getter permettant une circulation de gaz entre les premières faces (114, 116) des première et deuxième couches (104, 106) de matériau getter ;
- une première ouverture (112) traversant au moins la deuxième couche (106) de matériau getter et débouchant dans le premier espace (110) ;
**caractérisée en ce que** le matériau de la première portion (108) est apte à être gravé sélectivement par rapport aux matériaux getter des première et deuxième couches (104, 106).

2. Structure getter (100) selon la revendication 1, comportant en outre au moins :
- une troisième couche (120) de matériau getter telle que la deuxième couche (106) de matériau getter soit disposée entre la première couche (104) de matériau getter et la troisième couche (120) de matériau getter ;
- une deuxième portion de matériau (122) reliant mécaniquement une première face (128) de la troisième couche (120) de matériau getter à une deuxième face (118) de la deuxième couche (106) de matériau getter et formant au moins un deuxième espace (124) entre lesdites faces (118, 128) des deuxième et troisième couches (106, 120) de matériau getter permettant une circulation de gaz entre lesdites faces (118, 128) des deuxième et troisième couches (106, 120) de matériau getter ;
- une deuxième ouverture (126) traversant au moins la troisième couche (120) de matériau getter et débouchant dans le deuxième espace (124).

3. Structure getter (100) selon l'une des revendications précédentes, comportant n couches (104, 106, 120) de matériau getter superposées, espacées les unes des autres et structurées telles que 2n-1 faces actives (114, 116, 118, 128, 130) de matériau getter soient susceptibles d'être en contact avec un ou plusieurs gaz à absorber et/ou à adsorber, avec n nombre entier tel que n > 1.

4. Structure getter (100) selon l'une des revendications 2 ou 3, dans laquelle, lorsque la structure getter (100) comporte la troisième couche (120) de matériau getter, le matériau de la deuxième portion (122) est apte à être gravé sélectivement au moins par rapport aux matériaux getter des deuxième et troisième couches (106, 120).

5. Structure getter (100) selon l'une des revendications précédentes, dans laquelle les matériaux getter des première et deuxième couches (104, 106) comportent au moins du Ti et/ou du Zr et/ou du V, et le matériau de la première portion (108) comporte au moins du Ru et/ou du Cr et/ou du Cu et/ou du Ni et/ou de l'Al et/ou de l'Au, et/ou dans laquelle, lorsque la structure getter (100) comporte la troisième couche (120) de matériau getter, les matériaux getter des deuxième et troisième couches (106, 120) comportent au moins du Ti et/ou du Zr et/ou du V, et le matériau de la deuxième portion (122) comporte au moins du Ru et/ou du Cr et/ou du Cu et/ou du Ni et/ou de l'Al et/ou de l'Au.

6. Structure getter (100) selon l'une des revendications précédentes, comportant :
- plusieurs premières portions de matériau (108) reliant mécaniquement la première face (116) de la deuxième couche (106) de matériau getter à la première face (114) de la première couche (104) de matériau getter, et/ou
- plusieurs premières ouvertures (112) régulièrement réparties dans la deuxième couche (106) de matériau getter, et/ou
- lorsque la structure getter (100) comporte la troisième couche (120) de matériau getter, plusieurs deuxièmes portions de matériau (122) reliant mécaniquement la première face (128) de la troisième couche (120) de matériau getter à la deuxième face (118) de la deuxième couche (106) de matériau getter, et/ou
- lorsque la structure getter (100) comporte la troisième couche (120) de matériau getter, plusieurs deuxièmes ouvertures (126) régulièrement réparties dans la troisième couche (120) de matériau getter.

7. Structure getter (100) selon l'une des revendications précédentes, dans laquelle :
- la ou les premières ouvertures (112) comportent une surface totale, dans un plan parallèle à la deuxième face (118) de la deuxième couche (106) de matériau getter, inférieure ou égale à environ 20 % de la surface totale de la deuxième face (118) de la deuxième couche (106) de matériau getter, et/ou
- lorsque la structure getter (100) comporte la troisième couche (120) de matériau getter, la ou les deuxièmes ouvertures (126) comportent une surface totale, dans un plan parallèle à une deuxième face (130) de la troisième couche (120) de matériau getter opposée à la première face (128) de la troisième couche (120) de matériau getter, inférieure ou égale à environ 20 % de la surface totale de la deuxième face (130) de la troisième couche (120) de matériau getter, et/ou
- une partie de la surface de la première face (116) de la deuxième couche (106) de matériau getter qui est en contact avec la ou les premières portions de matériau (108) est inférieure ou égale à environ 20 % de la surface totale de la deuxième face (118) de la deuxième couche (106) de matériau getter, et/ou
- lorsque la structure getter (100) comporte la troisième couche (120) de matériau getter, une partie de la surface de la première face (128) de la troisième couche (120) de matériau getter qui est en contact avec la ou les deuxièmes portions de matériau (122) est inférieure ou égale à environ 20 % de la surface totale de la deuxième face (130) de la troisième couche (120) de matériau getter.

8. Structure getter (100) selon l'unes des revendications précédentes, dans laquelle la deuxième couche (106) de matériau getter comporte une section, dans un plan parallèle à la deuxième face (118) de la deuxième couche (106) de matériau getter, en forme de cadre rectangulaire ou en forme de grille, et/ou dans laquelle, lorsque la structure getter (100) comporte la troisième couche (120) de matériau getter, la troisième couche (120) de matériau getter comporte une section, dans un plan parallèle à la deuxième face (118) de la troisième couche (120) de matériau getter, en forme de cadre rectangulaire ou en forme de grille.

9. Structure getter (100) selon l'une des revendications précédentes, comportant en outre au moins une sous-couche (140) d'ajustement de la température d'activation thermique du matériau getter de la première couche (104), disposée entre le support (102) et la première couche (104) de matériau getter et comprenant au l'un des matériaux suivants : Ru, Pt, Cr, Cu, Ci, Al, Au.

10. Structure getter (100) selon l'une des revendications précédentes, comportant en outre au moins une couche de protection (134, 136, 138) recouvrant au moins une des faces (114, 116, 118, 128, 130) d'une des couches (104, 106, 120) de matériau getter.

11. Structure getter (100) selon la revendication 10, dans laquelle le matériau de la couche de protection (134, 136, 138) comporte de l'Au et/ou du Cr et/ou un oxyde d'un alliage ou d'un métal formant le matériau getter contre lequel la couche de protection (134, 136, 138) est disposée et/ou un nitrure de l'alliage ou du métal formant le matériau getter contre lequel la couche de protection (134, 136, 138) est disposée.

12. Structure getter (100) selon l'une des revendications précédentes, comportant en outre au moins une couche (138) apte à réfléchir un rayonnement infrarouge, disposée sur une face d'une des couches (106, 120) de matériau getter et formant une face avant de la structure getter (100).

13. Structure d'encapsulation (200) comportant au moins une cavité (210) fermée hermétiquement, délimitée par des premier et deuxième substrats (202, 206) et dans laquelle au moins un micro-dispositif (204) est disposé sur et/ou dans le premier substrat (202), et comportant en outre au moins une première structure getter (100) selon l'une des revendications précédentes dans laquelle le support de la première structure getter (100) est formé par le premier substrat (202) et/ou au moins une deuxième structure getter (100) selon l'une des revendications précédentes dans laquelle le support de la deuxième structure getter (100) est formé par le deuxième substrat (206).

14. Structure d'encapsulation (200) comportant au moins une cavité (210) fermée hermétiquement, délimitée par un substrat (202) et un capot (212) et dans laquelle au moins un micro-dispositif (204) est disposé sur et/ou dans le substrat (202), et comportant en outre au moins une première structure getter (100) selon l'une des revendications 1 à 12 formant au moins une paroi intérieure de la cavité (210) et/ou au moins une deuxième structure getter (100) selon l'une des revendications 1 à 12 dans laquelle le support de la deuxième structure getter (100) est formé par le substrat (202).

15. Procédé de réalisation d'une structure getter (100), comportant au moins la mise en œuvre des étapes de :
- réalisation d'au moins une première couche (104) de matériau getter sur un support (102) ;
- réalisation d'au moins une première couche de matériau sacrificiel sur une première face (114) de la première couche (104) de matériau getter ;
- réalisation d'au moins une deuxième couche (106) de matériau getter sur la première couche de matériau sacrificiel ;
- gravure d'au moins la deuxième couche (106) de matériau getter, formant au moins une première ouverture (112) traversant au moins la deuxième couche (106) de matériau getter ;
- gravure d'une partie de la première couche de matériau sacrificiel à travers la première ouverture (112), telle que le matériau sacrificiel restant de la première couche de matériau sacrificiel forme au moins une première portion de matériau (108) reliant mécaniquement une première face (116) de la deuxième couche (106) de matériau getter à la première face (114) de la première couche (104) de matériau getter, et formant au moins un premier espace (110) entre les premières faces (114, 116) des première et deuxième couches (104, 106) de matériau getter permettant une circulation de gaz entre les premières faces (114, 116) des première et deuxième couches (104, 106) de matériau getter et dans lequel débouche la première ouverture (112) ;
**caractérisé en ce que** le matériau de la première portion (108) est apte à être gravé sélectivement par rapport aux matériaux getter des première et deuxième couches (104, 106).

16. Procédé selon la revendication 15, dans lequel l'étape de gravure d'au moins la deuxième couche (106) de matériau getter grave également la première couche de matériau sacrificiel et la première couche (104) de matériau getter selon un motif similaire à celui de ladite au moins une première ouverture (112).

17. Procédé selon l'une des revendications 15 ou 16, comportant en outre, entre l'étape de réalisation de la deuxième couche (106) de matériau getter et l'étape de réalisation de la première ouverture (112), la mise en œuvre des étapes de :
- réalisation d'au moins une deuxième couche de matériau sacrificiel sur une deuxième face (118) de la deuxième couche (106) de matériau getter ;
- réalisation d'au moins une troisième couche (120) de matériau getter sur la deuxième couche de matériau sacrificiel ;
- gravure d'au moins la troisième couche (120) de matériau getter, formant au moins une deuxième ouverture (126) traversant au moins la troisième couche (120) de matériau getter ;
- gravure d'une partie de la deuxième couche de matériau sacrificiel à travers la deuxième ouverture (126), telle que le matériau sacrificiel restant de la deuxième couche de matériau sacrificiel forme au moins une deuxième portion de matériau (122) reliant mécaniquement une première face (128) de la troisième couche (120) de matériau getter à la deuxième face (118) de la deuxième couche (106) de matériau getter, et formant au moins un deuxième espace (124) entre lesdites faces (118, 128) des deuxième et troisième couches (106, 120) de matériau getter permettant une circulation de gaz entre lesdites faces (118, 128) des deuxième et troisième couches (106, 120) de matériau getter et dans lequel débouche la deuxième ouverture (126),
et dans lequel la gravure de la deuxième couche (106) de matériau getter est réalisée après la gravure de la partie de la deuxième couche de matériau sacrificiel et à travers la deuxième ouverture (126).

18. Procédé d'encapsulation d'au moins un micro-dispositif (204) disposé sur et/ou dans un premier substrat (202), comportant au moins les étapes suivantes :
- mise en œuvre d'un procédé de réalisation d'une première structure getter (100) selon l'une des revendications 15 à 17 et tel que le support de la première structure getter (100) soit formé par le premier substrat (202) et/ou d'un procédé de réalisation d'une deuxième structure getter (100) selon l'une des revendications 15 à 17 et tel que le support de la deuxième structure getter (100) soit formé par un deuxième substrat (206) ;
- solidarisation des premier et deuxième substrats (202, 206) l'un à l'autre, formant au moins une cavité (210) fermée hermétiquement, délimitée au moins par les premier et deuxième substrats (202, 206) et dans laquelle le micro-dispositif (204) est disposé.

19. Procédé d'encapsulation d'au moins un micro-dispositif (204) disposé sur et/ou dans un substrat (202), comportant au moins les étapes suivantes :
- réalisation d'une portion de matériau organique sur le substrat (202) et recouvrant au moins le micro-dispositif (204) ;
- mise en œuvre d'un procédé de réalisation d'une première structure getter (100) selon l'une des revendications 11 à 13, la première couche (104) de matériau getter étant réalisée sur la portion de matériau organique, et la première ouverture (112) étant réalisée telle qu'elle traverse la première couche de matériau getter (104) et la deuxième couche de matériau getter (106) ;
- gravure de la portion de matériau organique à travers la première ouverture (112) et, lorsque la première structure getter (100) comporte la troisième couche (120) de matériau getter, également à travers la deuxième ouverture (126) ;
- bouchage par dépôt d'au moins une couche de bouchage (212) sur la deuxième couche de matériau getter au moins au niveau de la première ouverture (112) ou, lorsque la première structure getter (100) comporte la troisième couche (120) de matériau getter, sur la troisième couche (120) de matériau getter au moins au niveau de la deuxième ouverture (126).

20. Procédé d'encapsulation selon la revendication 19, comportant en outre, préalablement à la réalisation de la portion de matériau organique, la mise en œuvre d'un procédé de réalisation d'une deuxième structure getter (100) selon l'une des revendications 15 à 17 et tel que le support de la deuxième structure getter (100) soit formé par le substrat (202), et dans lequel la portion de matériau organique est réalisée en recouvrant la deuxième structure getter (100).

21. Procédé d'encapsulation d'au moins un micro-dispositif (204) disposé sur et/ou dans un substrat (202), comportant au moins les étapes suivantes :
- mise en œuvre d'un procédé de réalisation d'une structure getter (100) selon l'une des revendications 15 à 17 et tel que le support de la structure getter (100) soit formé par le substrat (202) ;
- réalisation d'une portion de matériau organique sur le substrat (202) et recouvrant au moins le micro-dispositif (204) et la structure getter (100) ;
- dépôt d'au moins une couche capot (212) recouvrant la portion de matériau organique ;
- réalisation d'au moins une ouverture à travers la couche capot (212) ;
- gravure de la portion de matériau organique à travers l'ouverture ;
- dépôt d'au moins une couche de bouchage recouvrant la couche capot (212) au moins au niveau de l'ouverture.

22. Procédé selon l'une des revendications 19 à 21, dans lequel la couche de bouchage (212) comporte au moins un matériau getter.

## Patentansprüche

1. Getter-Struktur (100), welche wenigstens umfasst:
- einen Träger (102);
- eine erste Schicht (104) aus Getter-Material, die auf dem Träger (102) angeordnet ist;
- eine zweite Schicht (106) aus Getter-Material, so dass die erste Schicht (104) aus Getter-Material zwischen dem Träger (102) und der zweiten Schicht (106) aus Getter-Material angeordnet ist;
- einen ersten Materialabschnitt (108), der eine erste Fläche (116) der zweiten Schicht (106) aus Getter-Material mit einer ersten Fläche (114) der ersten Schicht (104) aus Getter-Material mechanisch verbindet und wenigstens einen ersten Raum (110) zwischen den ersten Flächen (114, 116) der ersten und zweiten Schicht (104, 106) aus Getter-Material bildet, der einen Gasstrom zwischen den ersten Flächen (114, 116) der ersten und zweiten Schichten (104, 106) aus Getter-Material ermöglicht;
- eine erste Öffnung (112), die durch wenigstens die zweite Schicht (106) aus Getter-Material hindurch verläuft und in den ersten Raum (110) mündet;
**dadurch gekennzeichnet, dass** das Material des ersten Abschnitts (108) dazu geeignet ist, in Bezug auf die Getter-Materialien der ersten und zweiten Schicht (104, 106) selektiv graviert zu werden.

2. Getter-Struktur (100) nach Anspruch 1, welche ferner wenigstens umfasst:
- eine dritte Schicht (120) aus Getter-Material, so dass die zweite Schicht (106) aus Getter-Material zwischen der ersten Schicht (104) aus Getter-Material und der dritten Schicht (120) aus Getter-Material angeordnet ist;
- einen zweiten Materialabschnitt (122), der eine erste Fläche (128) der dritten Schicht (120) aus Getter-Material mit einer zweiten Fläche (118) der zweiten Schicht (106) aus Getter-Material mechanisch verbindet und wenigstens einen zweiten Raum (124) zwischen den Flächen (118, 128) der zweiten und dritten Schicht (106, 120) aus Getter-Material bildet, der einen Gasstrom zwischen den Flächen (118, 128) der zweiten und dritten Schicht (106, 120) aus Getter-Material ermöglicht;
- eine zweite Öffnung (126), die wenigstens durch die dritte Schicht (120) aus Getter-Material hindurch verläuft und in den zweiten Raum (124) mündet.

3. Getter-Struktur (100) nach einem der vorhergehenden Ansprüche, umfassend n Schichten (104, 106, 120) aus Getter-Material, die übereinander angeordnet, voneinander beabstandet und so strukturiert sind, dass 2n-1 aktive Flächen (114, 116, 118, 128, 130) aus Getter-Material in Kontakt mit einem oder mehreren zu absorbierenden und/oder zu adsorbierenden Gasen stehen können, wobei n eine ganze Zahl ist, so dass n > 1 ist.

4. Getter-Struktur (100) nach einem der Ansprüche 2 oder 3, wobei, wenn die Getter-Struktur (100) die dritte Schicht (120) aus Getter-Material umfasst, das Material des zweiten Teils (122) dazu geeignet ist, wenigstens in Bezug auf die Getter-Materialien der zweiten und dritten Schicht (106, 120) selektiv graviert zu werden.

5. Getter-Struktur (100) nach einem der vorhergehenden Ansprüche, wobei die Getter-Materialien der ersten und zweiten Schicht (104, 106) wenigstens Ti und/oder Zr und/oder V umfassen und das Material des ersten Teils (108) wenigstens Ru und/oder Cr und/oder Cu und/oder Ni und/oder Al und/oder Au umfasst, und/oder, wenn die Getter-Struktur (100) die dritte Schicht (120) aus Getter-Material umfasst, die Getter-Materialien der zweiten und dritten Schicht (106, 120) wenigstens Ti und/oder Zr und/oder V umfassen, und das Material des zweiten Teils (122) wenigstens Ru und/oder Cr und/oder Cu und/oder Ni und/oder Al und/oder Au umfasst.

6. Getter-Struktur (100) nach einem der vorhergehenden Ansprüche, umfassend:
- mehrere erste Materialabschnitte (108), die die erste Fläche (116) der zweiten Schicht (106) aus Getter-Material mechanisch mit der ersten Fläche (114) der ersten Schicht (104) aus Getter-Material verbinden, und/oder
- mehrere erste Öffnungen (112), die regelmäßig in der zweiten Schicht (106) aus Getter-Material verteilt sind, und/oder
- wenn die Getter-Struktur (100) die dritte Schicht (120) aus Getter-Material umfasst, mehrere zweiten Materialabschnitte (122), die die erste Fläche (128) der dritten Schicht (120) aus Getter-Material mechanisch mit der zweiten Fläche (118) der zweiten Schicht (106) aus Getter-Material verbinden, und/oder
- wenn die Getter-Struktur (100) die dritte Schicht (120) aus Getter-Material umfasst, mehrere zweite Öffnungen (126), die regelmäßig in der dritten Schicht (120) aus Getter-Material verteilt sind.

7. Getter-Struktur (100) nach einem der vorhergehenden Ansprüche,wobei:
- die erste Öffnung oder die ersten Öffnungen (112) in einer Ebene parallel zu der zweiten Fläche (118) eine Gesamtoberfläche der zweiten Schicht (106) aus Getter-Material von weniger als oder gleich etwa 20% der Gesamtoberfläche der zweiten Fläche (118) der zweiten Schicht (106) aus Getter-Material aufweist/aufweisen, und/oder
- wenn die Getter-Struktur (100) die dritte Schicht (120) aus Getter-Material umfasst, die zweite Öffnung oder die zweiten Öffnungen (126) in einer Ebene parallel zu einer zweiten Fläche (130) der dritten Schicht (120) aus Getter-Material gegenüber der ersten Fläche (128) der dritten Schicht (120) aus Getter-Material eine Gesamtoberfläche von weniger als oder gleich etwa 20% der Gesamtoberfläche der zweiten Fläche (130) der dritten Schicht (120) aus Getter-Material aufweisen, und/oder
- ein Teil der Oberfläche der ersten Fläche (116) der zweiten Schicht (106) aus Getter-Material, die in Kontakt mit dem ersten Teil oder den ersten Teilen des Materials (108) steht, kleiner oder gleich etwa 20% der Gesamtoberfläche der zweiten Fläche (118) der zweiten Schicht (106) aus Getter-Material ist, und/oder
- wenn die Getter-Struktur (100) die dritte Schicht (120) aus Getter-Material umfasst, ein Teil der Oberfläche der ersten Fläche (128) der dritten Schicht (120) aus Getter-Material, die in Kontakt mit dem zweiten Teil oder den zweiten Teilen des Materials (122) steht, kleiner oder gleich etwa 20% der Gesamtoberfläche der zweiten Fläche (130) der dritten Schicht (120) aus Getter-Material ist.

8. Getter-Struktur (100) nach einem der vorhergehenden Ansprüche, wobei die zweite Schicht (106) aus Getter-Material in einer Ebene parallel zur zweiten Fläche (118) der zweiten Schicht (106) aus Getter-Material einen Abschnitt in Form eines rechteckigen Rahmens oder in Form eines Gitters aufweist, und/oder wobei, wenn die Getter-Struktur (100) die dritte Schicht (120) aus Getter-Material umfasst, die dritte Schicht (120) aus Getter-Material einen Abschnitt in einer Ebene parallel zur zweiten Fläche (118) der dritten Schicht (120) aus Getter-Material in Form eines rechteckigen Rahmens oder in Form eines Gitters umfasst.

9. Getter-Struktur (100) nach einem der vorhergehenden Ansprüche, welche ferner wenigstens eine Unterschicht (140) zum Einstellen der thermischen Aktivierungstemperatur des Getter-Materials der ersten Schicht (104) aufweist, die zwischen dem Träger (102) und der ersten Schicht (104) aus Getter-Material angeordnet ist und eines der folgenden Materialien aufweist: Ru, Pt, Cr, Cu, Ci, AI, Au.

10. Getter-Struktur (100) nach einem der vorhergehenden Ansprüche, welche ferner wenigstens eine Schutzschicht (134, 136, 138) aufweist, die wenigstens eine der Flächen (114, 116, 118, 128, 130) einer der Schichten (104, 106, 120) aus Getter-Material bedeckt.

11. Getter-Struktur (100) nach Anspruch 10, wobei das Material der Schutzschicht (134, 136, 138) Au und/oder Cr und/oder ein Oxid einer Legierung oder eines Metalls, das das Getter-Material bildet, gegen das die Schutzschicht (134, 136, 138) angeordnet ist, und/oder ein Nitrid der Legierung oder des Metalls, das das Getter-Material bildet, gegen das die Schutzschicht (134, 136, 138) angeordnet ist, umfasst.

12. Getter-Struktur (100) nach einem der vorhergehenden Ansprüche, welche ferner wenigstens eine Schicht (138) umfasst, die Infrarotstrahlung reflektieren kann, die auf einer Fläche einer der Schichten (106, 120) aus Getter-Material angeordnet ist und eine vordere Fläche der Getter-Struktur (100) bildet.

13. Verkapselungsstruktur (200), umfassend wenigstens einen hermetisch dichten Hohlraum (210), der durch ein erstes und ein zweites Substrat (202, 206) begrenzt ist und in dem wenigstens eine Mikrovorrichtung (204) auf und/oder in dem ersten Substrat (202) angeordnet ist, und ferner umfassend wenigstens eine erste Getter-Struktur (100) nach einem der vorhergehenden Ansprüche, wobei der Träger der ersten Getter-Struktur (100) durch das erste Substrat (202) gebildet ist, und/oder mit wenigstens einer zweiten Getter-Struktur (100) nach einem der vorhergehenden Ansprüche, wobei der Träger der zweiten Getter-Struktur (100) durch das zweite Substrat (206) gebildet ist.

14. Verkapselungsstruktur (200), umfassend wenigstens einen hermetisch dichten Hohlraum (210), der durch ein Substrat (202) und einen Deckel (212) begrenzt ist und in dem wenigstens eine Mikrovorrichtung (204) auf und/oder in dem Substrat (202) angeordnet ist, und ferner umfassend wenigstens eine erste Getter-Struktur (100) nach einem der Ansprüche 1 bis 12, die wenigstens eine Hohlrauminnenwand (210) bildet, und/oder wenigstens eine zweite Getter-Struktur (100) nach einem der Ansprüche 1 bis 12, wobei der Träger der zweiten Getter-Struktur (100) durch das Substrat (202) gebildet ist.

15. Verfahren zur Herstellung einer Getter-Struktur (100), welches wenigstens die Durchführung der folgenden Schritte umfasst:
- Herstellung wenigstens einer ersten Schicht (104) aus Getter-Material auf einem Träger (102);
- Herstellung wenigstens einer ersten Schicht aus Opfermaterial auf einer ersten Fläche (114) der ersten Schicht (104) aus Getter-Material;
- Herstellung wenigstens einer zweiten Schicht (106) aus Getter-Material auf der ersten Schicht aus Opfermaterial;
- Gravieren wenigstens der zweiten Schicht (106) aus Getter-Material, wobei wenigstens eine erste Öffnung (112) durch wenigstens die zweite Schicht (106) aus Getter-Material gebildet wird;
- Gravieren eines Teils der ersten Schicht aus Opfermaterial durch die erste Öffnung (112), so dass das verbleibende Opfermaterial der ersten Schicht aus Opfermaterial wenigstens einen ersten Materialabschnitt (108) bildet, der eine erste Fläche (116) der zweiten Schicht (106) aus Getter-Material mechanisch mit der ersten Fläche (114) der ersten Schicht (104) aus Getter-Material verbindet, und wenigstens einen ersten Raum (110) zwischen den ersten Flächen (114, 116) der ersten und zweiten Schichten (104, 106) aus Getter-Material bildet, der einen Gasstrom zwischen den ersten Flächen (114, 116) der ersten und zweiten Schichten (104, 106) aus Getter-Material ermöglicht und in den die erste Öffnung (112) mündet;
**dadurch gekennzeichnet, dass** das Material des ersten Abschnitts (108) geeignet ist, selektiv in Bezug auf die Getter-Materialien der ersten und zweiten Schicht (104, 106) graviert zu werden.

16. Verfahren nach Anspruch 15, wobei der Schritt des Gravierens wenigstens der zweiten Schicht (106) aus Getter-Material auch die erste Schicht aus Opfermaterial und die erste Schicht (104) aus Getter-Material in einem Muster ähnlich dem der wenigstens einen ersten Öffnung (112) graviert.

17. Verfahren nach einem der Ansprüche 15 oder 16, welches ferner zwischen dem Schritt der Herstellung der zweiten Schicht (106) aus Getter-Material und dem Schritt der Herstellung der ersten Öffnung (112) die Durchführung der folgenden Schritte umfasst:
- Bilden wenigstens einer zweiten Schicht aus Opfermaterial auf einer zweiten Fläche (118) der zweiten Schicht (106) aus Getter-Material;
- Bilden wenigstens einer dritten Schicht (120) aus Getter-Material auf der zweiten Schicht aus Opfermaterial;
- Gravieren wenigstens der dritten Schicht (120) aus Getter-Material, wobei wenigstens eine zweite Öffnung (126) gebildet wird, die durch wenigstens die dritte Schicht (120) aus Getter-Material hindurch verläuft;
- Gravieren eines Teils der zweiten Schicht aus Opfermaterial durch die zweite Öffnung (126), so dass das verbleibende Opfermaterial der zweiten Schicht aus Opfermaterial wenigstens einen zweiten Materialabschnitt (122) bildet, der eine erste Fläche (128) der dritten Schicht (120) aus Getter-Material mechanisch mit der zweiten Fläche (118) der zweiten Schicht (106) aus Getter-Material verbindet und wenigstens einen zweiten Raum (124) zwischen den Flächen (118, 128) der zweiten und dritten Schicht (106, 120) aus Getter-Material bildet, die eine Gasströmung zwischen den Flächen (118, 128) der zweiten und dritten Schicht (106, 120) aus Getter-Material ermöglicht und in die die zweite Öffnung (126) mündet,
und wobei das Gravieren der zweiten Schicht (106) aus Getter-Material nach dem Gravieren des Teils der zweiten Schicht aus Opfermaterial und durch die zweite Öffnung (126) hindurch durchgeführt wird.

18. Verfahren zum Verkapseln wenigstens einer Mikrovorrichtung (204), die auf und/oder in einem ersten Substrat (202) angeordnet ist, umfassend wenigstens die folgenden Schritte:
- Durchführung eines Verfahrens zur Herstellung einer ersten Getter-Struktur (100) nach einem der Ansprüche 15 bis 17 und derart, dass der Träger der ersten Getter-Struktur (100) durch das erste Substrat (202) gebildet wird und/oder eines Verfahrens zur Herstellung einer zweiten Getter-Struktur (100) nach einem der Ansprüche 15 bis 17 und derart, dass der Träger der zweiten Getter-Struktur (100) durch ein zweites Substrat (206) gebildet wird;
- Verbinden des ersten und zweiten Substrats (202, 206) miteinander, wobei wenigstens ein hermetisch abgedichteter Hohlraum (210) gebildet wird, der wenigstens durch das erste und zweite Substrat (202, 206) begrenzt wird und in dem die Mikrovorrichtung (204) angeordnet wird.

19. Verfahren zum Verkapseln wenigstens einer Mikrovorrichtung (204), die auf und/oder in einem Substrat (202) angeordnet ist, umfassend wenigstens die folgenden Schritte:
- Bereitstellen eines Teils des organischen Materials auf dem Substrat (202) und Bedecken wenigstens der Mikrovorrichtung (204);
- Durchführen eines Verfahrens zur Herstellung einer ersten Getter-Struktur (100) nach einem der Ansprüche 11 bis 13, wobei die erste Schicht (104) aus Getter-Material auf dem Teil des organischen Materials hergestellt wird, und die erste Öffnung (112) so hergestellt wird, dass sie durch die erste Schicht aus Getter-Material (104) und die zweite Schicht aus Getter-Material (106) hindurch verläuft;
- Gravieren des Anteils an organischem Material durch die erste Öffnung (112) und, wenn die erste Getter-Struktur (100) die dritte Schicht (120) aus Getter-Material umfasst, auch durch die zweite Öffnung (126);
- Versiegeln durch Aufbringen wenigstens einer Versiegelungsschicht (212) auf der zweiten Schicht aus Getter-Material wenigstens an der ersten Öffnung (112) oder, wenn die erste Getter-Struktur (100) die dritte Schicht (120) aus Getter-Material umfasst, auf der dritten Schicht (120) aus Getter-Material wenigstens an der zweiten Öffnung (126).

20. Verfahren zum Verkapseln nach Anspruch 19, welches ferner vor der Herstellung des Abschnitts aus organischem Material die Durchführung eines Verfahrens zur Herstellung einer zweiten Getter-Struktur (100) nach einem der Ansprüche 15 bis 17 und derart umfasst, dass der Träger der zweiten Getter-Struktur (100) durch das Substrat (202) gebildet wird, und wobei der Anteil an organischem Material durch Bedecken der zweiten Getter-Struktur (100) hergestellt wird.

21. Verfahren zum Verkapseln wenigstens einer Mikrovorrichtung (204), die auf und/oder in einem Substrat (202) angeordnet ist, umfassend wenigstens die folgenden Schritte:
- - Durchführen eines Verfahrens zur Herstellung einer Getter-Struktur (100) nach einem der Ansprüche 15 bis 17 und derart, dass der Träger der Getter-Struktur (100) durch das Substrat (202) gebildet wird;
- Herstellen eines Teils des organischen Materials auf dem Substrat (202) und Bedecken wenigstens der Mikrovorrichtung (204) und der Getter-Struktur (100);
- Aufbringen wenigstens einer Deckschicht (212), die den Abschnitt aus organischem Material bedeckt;
- Herstellen wenigstens einer Öffnung durch die Deckschicht (212);
- Gravieren des Abschnitts aus organischem Materials durch die Öffnung;
- Aufbringen wenigstens einer Deckschicht, die die Deckschicht (212) wenigstens an der Öffnung bedeckt.

22. Verfahren nach einem der Ansprüche 19 bis 21, wobei die Deckschicht (212) wenigstens ein Getter-Material umfasst.

## Claims

1. Getter structure (100) comprising at least:
- a support (102);
- a first layer (104) of getter material arranged on the support (102);
- a second layer (106) of getter material such that the first layer (104) of getter material is arranged between the support (102) and the second layer (106) of getter material;
- a first portion of material (108) mechanically connecting a first face (116) of the second layer (106) of getter material to a first face (114) of the first layer (104) of getter material and forming at least one first space (110) between the first faces (114, 116) of the first and second layers (104, 106) of getter material enabling a circulation of gas between the first faces (114, 116) of the first and second layers (104, 106) of getter material;
- a first opening (112) extending through at least the second layer (106) of getter material and emerging into the first space (110);
**characterized in that**
the material of the first portion (108) is capable of being etched selectively compared to the getter materials of the first and second layers (104, 106).

2. Getter structure (100) according to claim 1, further comprising at least:
- a third layer (120) of getter material such that the second layer (106) of getter material is arranged between the first layer (104) of getter material and the third layer (120) of getter material;
- a second portion of material (122) mechanically connecting a first face (128) of the third layer (120) of getter material to a second face (118) of the second layer (106) of getter material and forming at least one second space (124) between said faces (118, 128) of the second and third layers (106, 120) of getter material enabling a circulation of gas between said faces (118, 128) of the second and third layers (106, 120) of getter material;
- one second opening (126) extending through at least the third layer (120) of getter material and emerging into the second space (124).

3. Getter structure (100) according to one of previous claims, comprising n superimposed layers (104, 106, 120) of getter material, spaced apart and structured such that 2n-1 active faces (114, 116, 118, 128, 130) of getter material are capable of being in contact with one or more gases to absorb and/or adsorb, with n a whole number such that n > 1.

4. Getter structure (100) according to one of claims 2 or 3, in which, when the getter structure (100) comprises the third layer (120) of getter material, the material of the second portion (122) is capable of being etched selectively at least towards the getter materials of the second and third layers (106, 120).

5. Getter structure (100) according to one of previous claims, in which the getter materials of the first and second layers (104, 106) comprise at least Ti and/or Zr and/or V, and the material of the first portion (108) comprises at least Ru and/or Cr and/or Cu and/or Ni and/or Al and/or Au, and/or in which, when the getter structure (100) comprises the third layer (120) of getter material, the getter materials of the second and third layers (106, 120) comprise at least Ti and/or Zr and/or V, and the material of the second portion (122) comprises at least Ru and/or Cr and/or Cu and/or Ni and/or Al and/or Au.

6. Getter structure (100) according to one of previous claims, comprising:
- several first portions of material (108) mechanically connecting the first face (116) of the second layer (106) of getter material to the first face (114) of the first layer (104) of getter material, and/or
- several first openings (112) regularly spread out in the second layer (106) of getter material, and/or
- when the getter structure (100) comprises the third layer (120) of getter material, several second portions of material (122) mechanically connecting the first face (128) of the third layer (120) of getter material to the second face (118) of the second layer (106) of getter material, and/or
- when the getter structure (100) comprises the third layer (120) of getter material, several second openings (126) regularly spread out in the third layer (120) of getter material.

7. Getter structure (100) according to one of previous claims, in which:
- the first opening(s) (112) comprise a total surface, in a plane parallel to the second face (118) of the second layer (106) of getter material, less than or equal to around 20 % of the total surface of the second face (118) of the second layer (106) of getter material, and/or
- when the getter structure (100) comprises the third layer (120) of getter material, the second opening(s) (126) comprise a total surface, in a plane parallel to a second face (130) of the third layer (120) of getter material opposite to the first face (128) of the third layer (120) of getter material, less than or equal to around 20 % of the total surface of the second face (130) of the third layer (120) of getter material, and/or
- a part of the surface of the first face (116) of the second layer (106) of getter material which is in contact with the first portion(s) of material (108) is less than or equal to around 20 % of the total surface of the second face (118) of the second layer (106) of getter material, and/or
- when the getter structure (100) comprises the third layer (120) of getter material, a part of the surface of the first face (128) of the third layer (120) of getter material which is in contact with the second portion(s) of material (122) is less than or equal to around 20 % of the total surface of the second face (130) of the third layer (120) of getter material.

8. Getter structure (100) according to one of previous claims, in which the second layer (106) of getter material comprises a section, in a plane parallel to the second face (118) of the second layer (106) of getter material, of rectangular frame shape or of grid shape, and/or in which, when the getter structure (100) comprises the third layer (120) of getter material, the third layer (120) of getter material comprises a section, in a plane parallel to the second face (118) of the third layer (120) of getter material, of rectangular frame shape or of grid shape.

9. Getter structure (100) according to one of previous claims, further comprising at least one sub-layer (140) for adjusting the thermal activation temperature of the getter material of the first layer (104), arranged between the support (102) and the first layer (104) of getter material and including at least one of the following materials: Ru, Pt, Cr, Cu, Ci, Al, Au.

10. Getter structure (100) according to one of previous claims, further comprising at least one protective layer (134, 136, 138) covering at least one of the faces (114, 116, 118, 128, 130) of one of the layers (104, 106, 120) of getter material.

11. Getter structure (100) according to claim 10, in which the material of the protective layer (134, 136, 138) comprises at least Au and/or Cr and/or an oxide of an alloy or of a metal forming the getter material against which the protective layer (134, 136, 138) is arranged and/or a nitride of the alloy or of the metal forming the getter material against which the protective layer (134, 136, 138) is arranged.

12. Getter structure (100) according to one of previous claims, further comprising at least one layer (138) capable of reflecting an infrared radiation, arranged on a face of one of the layers (106, 120) of getter material and forming a front face of the getter structure (100).

13. Encapsulation structure (200) comprising at least one hermitically sealed cavity (210), delimited by first and second substrates (202, 206) and in which at least one micro-device (204) is arranged on and/or in the first substrate (202), and further comprising at least one first getter structure (100) according to one of previous claims in which the support of the first getter structure (100) is formed by the first substrate (102) and/or at least one second getter structure (100) according to one of previous claims in which the support of the second getter structure (100) is formed by the second substrate (206).

14. Encapsulation structure (200) comprising at least one hermitically sealed cavity (210), delimited by a substrate (202) and a cover (212) and in which at least one micro-device (204) is arranged on and/or in the substrate (202), and further comprising at least one first getter structure (100) according to one of claims 1 to 12 forming at least one inner wall of the cavity (210) and/or at least one second getter structure (100) according to one of claims 1 to 12 in which the support of the second getter structure (100) is formed by the substrate (202).

15. Method for producing a getter structure (100), comprising at least the implementation of the steps of:
- producing at least one first layer (104) of getter material on a support (102);
- producing at least one first layer of sacrificial material on a first face (114) of the first layer (104) of getter material;
- producing at least one second layer (106) of getter material on the first layer of sacrificial material;
- etching at least the second layer (106) of getter material, forming at least one first opening (112) extending through at least the second layer (106) of getter material;
- etching a part of the first layer of sacrificial material through the first opening (112), such that the remaining sacrificial material of the first layer of sacrificial material forms at least one first portion of material (108) mechanically connecting a first face (116) of the second layer (106) of getter material to the first face (114) of the first layer (104) of getter material, and forming at least one first space (110) between the first faces (114, 116) of the first and second layers (104, 106) of getter material enabling a circulation of gas between the first faces (114, 116) of the first and second layers (104, 106) of getter material and into which emerges the first opening (112);
**characterized in that**
the material of the first portion (108) is capable of being etched selectively compared to the getter materials of the first and second layers (104, 106).

16. Method according to claim 15, in which the step of etching at least the second layer (106) of getter material also etches the first layer of sacrificial material and the first layer (104) of getter material according to a pattern similar to that of said at least one first opening (112).

17. Method according to one of claims 15 or 16, further comprising, between the step of producing the second layer (106) of getter material and the step of making the first opening (112), the implementation of the steps of:
- producing at least one second layer of sacrificial material on a second face (118) of the second layer (106) of getter material;
- producing at least one third layer (120) of getter material on the second layer of sacrificial material;
- etching at least the third layer (120) of getter material, forming at least one second opening (126) extending through at least the third layer (120) of getter material;
- etching a part of the second layer of sacrificial material through the second opening (126), such that the remaining sacrificial material of the second layer of sacrificial material forms at least one second portion of material (122) mechanically connecting a first face (128) of the third layer (120) of getter material to the second face (118) of the second layer (106)of getter material, and forming at least one second space (124) between said faces (118, 128) of the second and third layers (106, 120) of getter material enabling a circulation of gas between said faces (116, 118) of the second and third layers (106, 120) of getter material and into which emerges the second opening (126),
and in which the etching of the second layer (106) of getter material is carried out after the etching of the part of the second layer of sacrificial material and through the second opening (126).

18. Method for encapsulating at least one micro-device (204) arranged on and/or in a first substrate (202), comprising at least the following steps:
- implementing a method for producing a first getter structure (100) according to one of claims 15 to 17 and such that the support of the first getter structure (100) is formed by the first substrate (202) and/or a method for producing a second getter structure (100) according to one of claims 15 to 17 and such that the support of the second getter structure (100) is formed by a second substrate (206);
- joining together the first and second substrates (202, 206), forming at least one hermitically sealed cavity (210), delimited at least by the first and second substrates (202, 206) and in which the micro-device (204) is arranged.

19. Method for encapsulating at least one micro-device (204) arranged on and/or in a substrate (202), comprising at least the following steps:
- producing a portion of organic material on the substrate (202) and covering at least the micro-device (204);
- implementing a method for producing a first getter structure (100) according to one of claims 11 to 13, the first layer (104) of getter material being produced on the portion of organic material, and the first opening (112) being produced such that it extends through the first layer of getter material (104) and the second layer of getter material (106);
- etching the portion of organic material through the first opening (112) and, when the first getter structure (100) comprises the third layer (120) of getter material, also through the second opening (126);
- sealing by depositing at least one sealing layer (212) on the second layer of getter material at least at the first opening (112) or, when the first getter structure (100) comprises the third layer (120) of getter material, on the third layer (120) of getter material at least at the second opening (126).

20. Method for encapsulating according to claim 19, further comprising, prior to the production of the portion of organic material, the implementation of a method for producing a second getter structure (100) according to one of claims 15 to 17 and such that the support of the second getter structure (100) is formed by the substrate (202), and in which the portion of organic material is produced by covering the second getter structure (100).

21. Method for encapsulating at least one micro-device (204) arranged on and/or in a substrate (202), comprising at least the following steps:
- implementing a method for producing a getter structure (100) according to one of claims 15 to 17 and such that the support of the getter structure (100) is formed by the substrate (202);
- producing a portion of organic material on the substrate (202) and covering at least the micro-device (204) and the getter structure (100);
- depositing at least one cover layer (212) covering the portion of organic material;
- making at least one opening through the cover layer (212);
- etching the portion of organic material through the opening;
- depositing at least one sealing layer covering the cover layer (212) at least at the opening.

22. Method according to one of claims 19 to 21, in which the sealing layer (212) comprises at least one getter material.
